# EUROPEAN PATENT APPLICATION

(11) **EP 4 601 425 A1**
(43) Date of publication of application: **13.08.2025**
(21) Application number: 25154617.2
(22) Date of filing: 29.01.2025
(51) Int. Cl.: H05K 7/14, B60L 53/22, H02M 7/00, H05K 7/20

(54) **ALL-IN-ONE POWER SUPPLY APPARATUS, ALL-IN-ONE POWERTRAIN, AND ELECTRIC VEHICLE**

(30) Priority: 08.02.2024 CN 202410179470
(71) Applicant: Huawei Digital Power Technologies Co., Ltd., Shenzhen, Guangdong 518043 (CN)
(72) Inventor: Lu, Mugui, Shenzhen, 518043 (CN); Du, Lin, Shenzhen, 518043 (CN); Yao, Zirong, Shenzhen, 518043 (CN)
(74) Representative: Gill Jennings & Every LLP

(57) **Abstract**

This application provides an all-in-one power supply apparatus. The power supply apparatus is configured to: charge and discharge a battery, and drive a motor. The power supply apparatus includes an integrated groove housing, a radiator, an upper-layer circuit board, and a lower-layer circuit board. The integrated groove housing includes a bottom plate, the bottom plate includes a first flow channel and a second flow channel, and the first flow channel is configured to communicate the second flow channel and the radiator. The first flow channel and the second flow channel are arranged in a first direction. The first flow channel, the upper-layer circuit board, and the radiator are sequentially stacked in a third direction, and the first flow channel and the radiator are configured to cool an electrical component in an on-board charger carried on the upper-layer circuit board. The second flow channel and the lower-layer circuit board are stacked in the third direction, and the second flow channel is configured to cool a power module of a motor control unit carried on a lower surface of the lower-layer circuit board. The first flow channel and the radiator cool the upper-layer circuit board, and the first flow channel and the second flow channel are arranged in a flat manner, so that a heat dissipation path for a coolant in the power supply apparatus is longer, thereby effectively improving heat dissipation efficiency of the power supply apparatus.

## Description

### TECHNICAL FIELD

This application relates to the field of electric vehicle technologies, and in particular, to an all-in-one power supply apparatus, an all-in-one powertrain, and an electric vehicle.

### BACKGROUND

An existing electric vehicle usually uses a powertrain as a power source. Currently, the powertrain includes a plurality of components such as a motor, a reducer, a motor control unit, and a heat exchanger. To diversify functions of the powertrain, more functional modules are integrated into the motor control unit. As a result, a temperature of an internal component in the motor control unit increases during operating, and operating efficiency of the internal functional modules of the motor control unit is affected. Generally, heat is dissipated for a device by attaching a water channel to the device. This cannot meet a heat dissipation requirement of the motor control unit.

### SUMMARY

This application provides an all-in-one power supply apparatus, an all-in-one powertrain, and an electric vehicle.

According to a first aspect, an embodiment of this application provides an all-in-one power supply apparatus. The power supply apparatus is configured to: charge and discharge a battery, and drive a motor. The power supply apparatus includes an integrated groove housing, a radiator, an upper-layer circuit board, and a lower-layer circuit board. The integrated groove housing includes a bottom plate, the bottom plate includes a first flow channel and a second flow channel, and the first flow channel is configured to communicate the second flow channel and the radiator. The first flow channel and the second flow channel are arranged in a first direction. The first flow channel, the upper-layer circuit board, and the radiator are sequentially stacked in a third direction, and the first flow channel and the radiator are configured to cool an electrical component in an on-board charger carried on the upper-layer circuit board. The second flow channel and the lower-layer circuit board are stacked in the third direction, and the second flow channel is configured to cool a power module of a motor control unit carried on a lower surface of the lower-layer circuit board.

In this embodiment of this application, the integrated groove housing is configured to fasten and mount the radiator, the upper-layer circuit board, and the lower-layer circuit board. The radiator, the upper-layer circuit board, and the lower-layer circuit board are supported by the integrated groove housing, so that the radiator, the upper-layer circuit board, and the lower-layer circuit board are fastened to the integrated groove housing with high stability. In this way, overall structural strength of the power supply apparatus is stronger, and an electrical connection is more stable. When an external environment exerts external force on the power supply apparatus, the radiator, the upper-layer circuit board, the lower-layer circuit board, and the integrated groove housing are not easily displaced relative to each other. This helps the power supply apparatus operate in a stable state.

In this embodiment of this application, the power supply apparatus generates a large amount of heat in an operating process, and heat dissipation needs to be performed on the power supply apparatus to ensure that a component in the power supply apparatus operates normally. The bottom plate includes the first flow channel and the second flow channel. The first flow channel and the second flow channel are configured to cool the electrical components carried by the upper-layer circuit board and the lower-layer circuit board in the power supply apparatus. The first flow channel is configured to communicate the second flow channel and the radiator, to facilitate communication of a coolant in the power supply apparatus. In an embodiment, after entering the power supply apparatus, the coolant sequentially passes through the radiator, the first flow channel, and the second flow channel, to implement series circulation cooling of the coolant in the power supply apparatus. In an embodiment, after the coolant enters the power supply apparatus, one part of the coolant flows through the radiator and the first flow channel to the second flow channel, and the other part of the coolant directly flows from the first flow channel to the second flow channel without passing through the radiator. The two parts of the coolant converge in the second flow channel, to implement parallel circulation of the coolant in the power supply apparatus for cooling.

In this embodiment of this application, the first flow channel and the second flow channel are arranged in the first direction, and primary regions of the upper-layer circuit board and the lower-layer circuit board are also arranged in the first direction. This helps the first flow channel and the second flow channel cool the lower-layer circuit board and the upper-layer circuit board.

In this embodiment of this application, the first flow channel and the radiator are configured to cool the electrical component that is of the on-board charger and that is carried by the upper-layer circuit board. The first flow channel, the upper-layer circuit board, and the radiator are sequentially stacked in the third direction. The upper-layer circuit board is sandwiched between the first flow channel and the radiator. This helps the coolant in the first flow channel and the radiator dissipate heat for the electrical component in the on-board charger on the upper-layer circuit board, improves heat dissipation efficiency, and improves cooling effect of the coolant on the power supply apparatus.

In this embodiment of this application, the second flow channel is configured to cool the power module of the motor control unit carried on the lower surface of the lower-layer circuit board. The second flow channel and the lower-layer circuit board are stacked in the third direction. Therefore, the second flow channel covers a mounting region in which the power module of the motor control unit is mounted on the bottom plate. In this way, the second flow channel cools the power module of the motor control unit as much as possible, thereby improving cooling efficiency.

In an embodiment, the first flow channel is configured to cool at least one of a transformer, a plurality of inductors, and a plurality of capacitors in the on-board charger carried on a lower surface of the upper-layer circuit board, and the radiator is configured to cool a plurality of power switching transistors of the on-board charger carried on an upper surface of the upper-layer circuit board.

In this embodiment of this application, the first flow channel is located on the bottom plate. The transformer, the plurality of inductors, and the plurality of capacitors in the on-board charger are sequentially arranged on the lower surface of the upper-layer circuit board in a second direction. The first flow channel is configured to cool at least one of the transformer, the plurality of inductors, and the plurality of capacitors in the on-board charger that are carried on the lower surface of the upper-layer circuit board. In this way, at least one of the transformer, the plurality of inductors, and the plurality of capacitors in the on-board charger can be cooled in time when the on-board charger operates. This helps reduce a temperature in the power supply apparatus, and ensures normal operating of the power supply apparatus.

In this embodiment of this application, the radiator is configured to cool the plurality of power switching transistors of the on-board charger carried on the upper surface of the upper-layer circuit board. The plurality of power switching transistors of the on-board charger are closer to the radiator than the first flow channel, so that the radiator can cool the plurality of power switching transistors of the on-board charger. This helps reduce the temperature in the power supply apparatus, and ensures normal operating of the power supply apparatus.

In this embodiment of this application, the first flow channel and the radiator are respectively configured to cool the electrical components carried on the lower surface and the lower surface of the upper-layer circuit board. Some electrical components in the upper-layer circuit board are stacked between the upper-layer circuit board and the bottom plate, and some electrical components are stacked between the upper-layer circuit board and the radiator. This not only improves cooling and heat dissipation effect of the electrical components, but also can fully use space of the upper surface and the lower surface of the upper-layer circuit board, so that the components are arranged more compactly, a heat dissipation and cooling region is more centralized, and heat dissipation effect is better. This improves power density and operating efficiency of the power supply apparatus.

In an embodiment, the lower-layer circuit board includes a primary region and a secondary region, a lower surface of the primary region is configured to fasten the power module of the motor control unit, and the secondary region is configured to fasten at least a part of power switching transistors of a direct current converter. The primary region and the secondary region are arranged in the first direction. The first flow channel, the secondary region, and the upper-layer circuit board are stacked in the third direction. The second flow channel and the primary region are stacked in the third direction.

In this embodiment of this application, the lower surface of the primary region of the lower-layer circuit board is configured to fasten the power module of the motor control unit, and the secondary region of the lower-layer circuit board is configured to fasten the at least a part of power switching transistors of the direct current converter, so that the power module of the fastened motor control unit and the at least a part of power switching transistors of the direct current converter are integrated into the lower-layer circuit board. This helps improve integration of the power supply apparatus and reduce a quantity of used circuit boards.

In this embodiment of this application, the primary region and the secondary region are arranged in the first direction, and the first flow channel and the second flow channel are arranged in the first direction. This makes it possible for the first flow channel and the second flow channel to jointly cool the lower-layer circuit board, and helps improve cooling efficiency of the lower-layer circuit board. The first flow channel, the secondary region, and the upper-layer circuit board are stacked in the third direction, so that the first flow channel can not only cool the upper-layer circuit board, but also cool the secondary region of the lower-layer circuit board, thereby improving efficiency of cooling the power supply apparatus by the coolant. The second flow channel and the primary region are stacked in the third direction, so that the second flow channel cools the primary region of the lower-layer circuit board, to ensure normal operating of the electrical component in the lower-layer circuit board.

In an embodiment, the bottom plate includes a first flow channel groove and a second flow channel groove, the first flow channel groove is recessed in the third direction from a lower surface of the bottom plate to the upper-layer circuit board, the first flow channel groove is configured to form the first flow channel, the second flow channel groove is recessed in the third direction from the upper surface of the bottom plate and away from the lower-layer circuit board, and the second flow channel groove is configured to form the second flow channel.

In this embodiment of this application, the first flow channel groove and the second flow channel groove of the bottom plate make it possible for the coolant to flow in the power supply apparatus. The first flow channel groove is recessed in the third direction from the lower surface of the bottom plate to the upper-layer circuit board, to help form the first flow channel on the lower surface of the bottom plate. In this way, arrangement of the first flow channel does not affect mounting and arrangement of the electrical components in the upper-layer circuit board and the lower-layer circuit board in the power supply apparatus. The second flow channel groove is recessed in the third direction from the upper surface of the bottom plate to the direction away from the lower-layer circuit board. This helps form the second flow channel on the upper surface of the bottom plate. The second flow channel is formed on the upper surface of the bottom plate, and the second flow channel is closer to the lower-layer circuit board. This helps the second flow channel cool the lower-layer circuit board. This helps enable a difference between heights of a primary region corresponding to an inner cavity of the integrated groove housing and two parts of the upper-layer circuit board in the third direction to be small, so that components in the inner cavity of the integrated groove housing are arranged in a more regular and orderly manner.

In an embodiment, in the third direction, a spacing between a groove bottom of the first flow channel groove and the radiator is less than a spacing between a groove bottom of the second flow channel groove and the radiator.

In this embodiment of this application, the first flow channel groove is located on the lower surface of the bottom plate. In the third direction, the spacing between the groove bottom of the first flow channel groove and the radiator is small. In other words, the coolant in the radiator and the coolant in the first flow channel are closer to the upper-layer circuit board. This helps cool the upper-layer circuit board. The second flow channel groove is located on the upper surface of the bottom plate. In the third direction, the spacing between the groove bottom of the second flow channel groove and the radiator is large, to provide larger space for the second flow channel groove to form the second flow channel, so that more coolants flow through the second flow channel. In this way, the lower-layer circuit board is better cooled, and more space is provided for mounting the electrical component in the lower-layer circuit board.

In this embodiment of this application, the groove bottom of the first flow channel groove and the groove bottom of the second flow channel groove are staggered in the third direction toward each other. In comparison with a solution in which the groove bottom of the first flow channel groove and the groove bottom of the second flow channel groove are staggered in the third direction away from each other, or in comparison with a solution in which the groove bottom of the first flow channel groove and the groove bottom of the second flow channel groove are aligned in the third direction, in this solution, a length of the first flow channel groove and a length of the second flow channel groove in the third direction can be reduced, so that a length of the power supply apparatus in the third direction can be reduced, thereby facilitating miniaturization of the power supply apparatus.

In an embodiment, a length of the first flow channel groove in the first direction is greater than a length of the second flow channel groove in the first direction, and a length of the first flow channel groove in the second direction is greater than a length of the second flow channel groove in the second direction.

In this embodiment of this application, the length of the first flow channel groove in the first direction is large, so that a surface area of the first flow channel adjacent to the electrical component in the upper-layer circuit board is larger, and more coolants flow through the first flow channel in the first flow channel groove. This helps improve efficiency of cooling the upper-layer circuit board by the first flow channel. The length of the second flow channel groove in the first direction is small, so that more mounting space is provided for the plurality of chips of a vehicle control unit.

In this embodiment of this application, the length of the first flow channel groove in the second direction is large. This helps the first flow channel dissipate heat for more electrical components in the upper-layer circuit board in the second direction, and improves cooling efficiency on the upper-layer circuit board. Because the second flow channel groove is disposed on the upper surface of the bottom plate, the length of the second flow channel groove in the second direction is small, and more mounting space is provided for a bus capacitor and a power distribution unit of the motor control unit.

In an embodiment, a groove peripheral wall of the second flow channel groove includes a communication hole, and the communication hole is configured to communicate with the first flow channel groove. A part of the groove peripheral wall of the second flow channel groove is adjacent to a part of the groove peripheral wall of the first flow channel groove in the first direction. The communication hole penetrates, in the first direction, the part of the groove peripheral wall of the second flow channel groove and the part of the groove peripheral wall of the first flow channel groove that are adjacent to each other.

In this embodiment of this application, the communication hole communicates the first flow channel groove with the second flow channel groove, so that the coolant in the first flow channel can flow into the second flow channel from the communication hole. This facilitates circulation of the coolant in the power supply apparatus, and helps improve a fusion degree of the power supply apparatus.

In this embodiment of this application, the part of the groove peripheral wall of the second flow channel groove is adjacent to the part of the groove peripheral wall of the first flow channel groove in the first direction, so that it is possible to provide the communication hole on the groove peripheral wall of the second flow channel groove to communicate the second flow channel groove with the first flow channel groove.

In this embodiment of this application, the communication hole penetrates, in the first direction, the part of the groove peripheral wall of the second flow channel groove and the part of the groove peripheral wall of the first flow channel groove that are adjacent to each other, so that the coolant in the first flow channel flows into the second flow channel in the first direction, and a flow path between the first flow channel and the second flow channel is shortened.

In an embodiment, a groove peripheral wall of the second flow channel groove includes a communication hole, and the communication hole is configured to communicate with the first flow channel groove. A part of a groove bottom wall of the second flow channel groove is adjacent to a part of a groove bottom wall of the first flow channel groove in the third direction. The communication hole penetrates, in the third direction, the part of the groove bottom wall of the second flow channel groove and the part of the groove bottom wall of the first flow channel groove that are adjacent to each other.

In this embodiment of this application, the communication hole communicates the first flow channel groove with the second flow channel groove, so that the coolant in the first flow channel can flow into the second flow channel from the communication hole. This facilitates circulation of the coolant in the power supply apparatus, and helps improve a fusion degree of the power supply apparatus.

In this embodiment of this application, the groove bottom of the first flow channel groove is located on the lower surface of the bottom plate, the groove bottom of the second flow channel groove is located on the upper surface of the bottom plate, and the part of the groove bottom wall of the second flow channel groove is adjacent to the part of the groove bottom wall of the first flow channel groove in the third direction. This provides space for the coolant in the first flow channel in the first flow channel groove to flow into the second flow channel in the second flow channel groove.

In this embodiment of this application, the communication hole penetrates, in the third direction, the part of the groove bottom wall of the second flow channel groove and the part of the groove bottom wall of the first flow channel groove that are adjacent to each other, so that the coolant in the first flow channel flows into the second flow channel through the communication hole in the third direction, and a flow path between the first flow channel and the second flow channel is shortened. This helps improve the overall fusion degree in the power supply apparatus.

In an embodiment, a peripheral side wall of the integrated groove housing includes a liquid inlet, the bottom plate includes a liquid outlet, the groove peripheral wall of the second flow channel groove includes the communication hole, the liquid inlet is configured to communicate with the radiator and the first flow channel groove, the liquid outlet is configured to communicate with the second flow channel, and the communication hole is configured to communicate with the first flow channel groove and the second flow channel groove. The liquid outlet, the communication hole, and the liquid inlet are sequentially spaced in the first direction. The liquid outlet penetrates the groove bottom of the second flow channel groove in the third direction. An opening of the liquid inlet faces away from an inner cavity of the integrated groove housing in the first direction.

In this embodiment of this application, the liquid inlet is configured to input a coolant in a vehicle cooling system into the power supply apparatus, the liquid outlet is configured to output the heated coolant obtained after the power supply apparatus is cooled, and the liquid inlet is located on the peripheral side wall of the integrated groove housing. This facilitates arrangement of an external cooling pipe connected to the liquid inlet. The liquid outlet is located on the bottom plate of the integrated groove housing. This helps the coolant flowing out of the power supply apparatus in a gravity direction after a temperature rises, and helps reduce a power loss.

In this embodiment of this application, the liquid inlet is configured to communicate with the radiator and the first flow channel groove, and the coolant in the vehicle cooling system flows into the radiator and the first flow channel groove from the liquid inlet, so that the coolant in the radiator and the coolant in the first flow channel groove simultaneously cool the upper-layer circuit board. This helps improve cooling efficiency of the power supply apparatus. The liquid outlet is configured to communicate with the second flow channel, so that the coolant in the second flow channel can flow out of the power supply apparatus from the liquid outlet. The coolant from the vehicle cooling system sequentially flows through the liquid inlet, the first flow channel, the communication hole, the second flow channel, and the liquid outlet, or sequentially flows through the liquid inlet, the radiator, the first flow channel, the communication hole, the second flow channel, and the liquid outlet.

In this embodiment of this application, the liquid outlet, the communication hole, and the liquid inlet are sequentially spaced in the first direction, so that the first flow channel and the second flow channel are arranged in the first direction, and the coolant smoothly flows through the liquid inlet, the communication hole, and the liquid outlet in sequence.

In this embodiment of this application, the liquid outlet penetrates the groove bottom of the second flow channel groove in the third direction, so that the external cooling pipe connected to the liquid outlet is arranged below the power supply apparatus in the third direction, and the coolant flows out of the power supply apparatus from the groove bottom of the second flow channel groove in the gravity direction, thereby reducing a power loss. The opening of the liquid inlet faces away from the inner cavity of the integrated groove housing in the first direction, to facilitate connection and mounting of the external pipe connected to the liquid inlet.

In an embodiment, the first flow channel groove includes a separation rib, the separation rib is configured to separate the first flow channel groove into two flow channel sub-grooves, and the two flow channel sub-grooves are spaced in the second direction. An inlet of one of the flow channel sub-grooves is configured to communicate with the liquid inlet through an internal oil channel of the integrated groove housing, the other one of the flow channel sub-grooves is configured to communicate with an outlet of the radiator through the internal oil channel of the integrated groove housing, and outlets of the two flow channel sub-grooves are configured to communicate with the communication hole of the second flow channel groove.

In this embodiment of this application, the separation rib is fastened to the lower surface of the bottom plate and extends in the third direction, and the separation rib separates the first flow channel groove into two flow channel sub-grooves, so that the coolant input from the liquid inlet flows through one of the flow channel sub-grooves in a more centralized manner. A flowing speed of the coolant in the one flow channel sub-groove is increased, so that a coolant with a low temperature is continuously input into the one flow channel sub-groove. This helps improve cooling efficiency of the power supply apparatus. In addition, after the coolant is input into the radiator from the liquid inlet, the coolant in the radiator may flow out of the power supply apparatus through the other flow channel sub-groove.

In this embodiment of this application, the coolant from the vehicle cooling system may flow out of the power supply apparatus through the liquid inlet, the inlet of the one flow channel sub-groove, the one flow channel sub-groove, the outlet of one flow channel sub-groove, the communication hole, the second flow channel groove, and the liquid outlet in sequence. The coolant may flow out of the power supply apparatus through the liquid inlet, the radiator, the outlet of the radiator, the other flow channel sub-groove, the outlet of the other flow channel sub-groove, the communication hole, the second flow channel groove, and the liquid outlet in sequence. The first flow channel groove is separated into the two flow channel sub-grooves. When the coolant flowing in the other flow channel sub-groove is a coolant whose temperature increases in the radiator, it can be ensured that the coolant in the one flow channel sub-groove is a coolant with a low temperature that is directly from the vehicle cooling system. This helps ensure cooling effect of the first flow channel groove on the upper-layer circuit board.

In an embodiment, the bottom plate further includes a power distribution groove, a bus capacitor groove, and a three-phase connector mounting hole, the power distribution groove is configured to accommodate a copper bar of the power distribution unit, the bus capacitor groove is configured to accommodate a bus capacitor of the motor control unit, and the three-phase connector mounting hole is configured to fasten a connector between the motor control unit and a motor winding. The three-phase connector mounting hole, the second flow channel groove, the bus capacitor groove, and the power distribution groove are sequentially arranged in the second direction.

In this embodiment of this application, the power distribution groove is configured to accommodate the copper bar of the power distribution unit. The power distribution unit converts a high voltage direct current output by the battery into a direct current voltage or an alternating current required by a load when the load operates, to supply power to the load. The copper bar of the power distribution unit is further connected to a connector in a direct current input connector mounting hole and a connector in a battery charge and discharge connector mounting hole, and is configured to transmit a direct current of a direct current power supply to the battery to charge the battery. The bus capacitor groove is configured to accommodate the bus capacitor of the motor control unit. The bus capacitor can smooth a bus voltage, so that the bus voltage of the motor control unit is still smooth when the power switching transistor is turned on or off, can further reduce an inductance parameter of a line from a power switching transistor end of the motor control unit to an end of the battery, to weak a peak voltage of the bus, can further absorb a high pulse current at a bus end of the motor control unit, and can further prevent overcharge of a voltage at the bus end and impact of an instantaneous voltage on the motor control unit. The three-phase connector mounting hole is configured to fasten the connector between the motor control unit and the motor winding. The connector between the motor control unit and the motor winding transmits an alternating current of the motor control unit to the motor winding, to drive a rotor and a motor shaft of the motor to rotate.

In this embodiment of this application, the three-phase connector mounting hole, the second flow channel groove, the bus capacitor groove, and the power distribution groove are sequentially arranged in the second direction. This helps regular arrangement of the electrical components on the power supply apparatus. In addition, a three-phase copper bar component, the power module, the bus capacitor, and the copper bar of the power distribution unit are sequentially arranged in the second direction. This helps cool the power module by using the coolant in the second flow channel groove.

In this embodiment of this application, the second flow channel groove and the power distribution groove are spaced through the bus capacitor groove, to prevent a cooling medium penetrating the second flow channel groove in an extreme case from affecting power transmission of the copper bar in the power distribution groove, and ensure cooling effect and stability of transmission power of the copper bar.

In an embodiment, the bottom plate further includes a communication connector mounting hole, and the communication connector mounting hole is configured to fasten a connector between a vehicle control unit and a vehicle-mounted load. The communication connector mounting hole, the second flow channel groove, and the first flow channel groove are sequentially arranged in the first direction.

In this embodiment of this application, the communication connector mounting hole is configured to fasten the connector between the vehicle control unit and the vehicle-mounted load. The vehicle control unit is configured to transmit a communication signal of the vehicle-mounted load to the power supply apparatus, to control the power supply apparatus. The communication connector mounting hole, the second flow channel groove, and the first flow channel groove are sequentially arranged in the first direction, to facilitate arrangement and normalization of the electrical components on the power supply apparatus. The liquid outlet is located between the second flow channel groove and the communication connector mounting hole, so that when the coolant in the first flow channel groove and the coolant in the second flow channel groove are discharged from the external cooling pipe connected to the liquid outlet, the external cooling pipe connected to the liquid outlet does not occupy too much space of the power supply apparatus in the first direction. This facilitates a compact layout of the powertrain, and optimizes vehicle performance.

In this embodiment of this application, the communication connector mounting hole and the three-phase connector mounting hole are distributed on two adjacent sides of the second flow channel groove, so that the cooling medium of the second flow channel groove can absorb heat of the connectors in the communication connector mounting hole and the three-phase connector mounting hole, to cool the connectors in the communication connector mounting hole and the three-phase connector mounting hole. This helps signal transmission of the communication connector in the communication connector mounting hole be more stable, and helps the connector in the three-phase connector mounting hole transmit power more quickly, to avoid heat generation.

In an embodiment, the upper surface of the bottom plate further includes a transformer groove, an inductor groove, and a direct current filter groove, the transformer groove is configured to accommodate the transformer of the on-board charger, the inductor groove is configured to accommodate the plurality of inductors in the on-board charger, and the direct current filter groove is configured to accommodate a magnetic component in a direct current filter. At least one of the transformer groove, the inductor groove, and the direct current filter groove is stacked between the first flow channel groove and the upper-layer circuit board in the third direction. The transformer groove, the inductor groove, the direct current filter groove, and the first flow channel groove are arranged on a same side of the second flow channel groove in the first direction.

In this embodiment of this application, the transformer groove and the inductor groove are arranged in the second direction, and the transformer groove and the direct current filter groove are arranged in the first direction. The transformer groove is configured to accommodate the transformer of the on-board charger, the inductor groove is configured to accommodate the plurality of inductors in the on-board charger, and the direct current filter groove is configured to accommodate the magnetic component in the direct current filter. The transformer groove, the inductor groove, and the direct current filter groove are disposed, so that structural firmness of the integrated groove housing can be improved. This helps improve stability of the power supply apparatus, and reduce electrical impact between module components.

In this embodiment of this application, at least one of the transformer groove, the inductor groove, and the direct current filter groove is stacked between the first flow channel groove and the upper-layer circuit board in the third direction. This helps the coolant in the first flow channel groove cool at least one of the transformer of the on-board charger, the plurality of inductors in the on-board charger, and the magnetic component in the direct current filter.

In this embodiment of this application, the transformer groove, the inductor groove, the direct current filter groove, and the first flow channel groove are arranged on a same side of the second flow channel groove in the first direction. This helps arrange the transformer of the on-board charger, the plurality of inductors in the on-board charger, and the magnetic component in the direct current filter on the lower surface of the upper-layer circuit board. This helps improve integration and fusion of the power supply apparatus, and further helps the first flow channel groove cool the transformer of the on-board charger in the transformer groove, the plurality of inductors in the on-board charger in the inductor groove, and the magnetic component in the direct current filter in the direct current filter groove. In this way, cooling of the power supply apparatus is implemented, and stable running of the power supply apparatus is ensured.

According to a second aspect, an embodiment of this application provides an all-in-one powertrain. The powertrain includes a motor, a reducer, and the power supply apparatus according to any one of the foregoing implementations. The power supply apparatus is connected to a winding of the motor through a motor control unit to drive the motor. A motor shaft of the motor is in transmission connection to an input shaft of the reducer.

In this embodiment of this application, the power supply apparatus is configured to charge and discharge a battery and drive the motor. The power supply apparatus is configured to receive a direct current transmitted by the battery, convert the direct current into an alternating current, and transmit the alternating current to the motor. The power supply apparatus is connected to the winding of the motor through the motor control unit to drive the motor. The motor shaft of the motor is in transmission connection to the input shaft of the reducer, to drive the reducer to operate. The first flow channel and the radiator in the power supply apparatus are communicated in series or in parallel. The first flow channel and the radiator simultaneously cool the upper-layer circuit board. The second flow channel cools the power module. The first flow channel and the second flow channel are arranged in a flat manner. In this way, a heat dissipation path of the coolant in the power supply apparatus is longer, thereby effectively improving heat dissipation efficiency of the power supply apparatus, and further improving heat dissipation efficiency of the powertrain.

According to a third aspect, an embodiment of this application provides an electric vehicle. The electric vehicle includes a vehicle frame, a power battery, and the foregoing powertrain. The vehicle frame is configured to fasten the power battery and the powertrain. The power battery is configured to connect to the power supply apparatus.

In this embodiment of this application, the power supply apparatus is configured to charge and discharge the power battery and drive the motor of the powertrain. The power supply apparatus in the powertrain is provided with the first flow channel, the second flow channel, and the radiator. The first flow channel and the radiator simultaneously cool the upper-layer circuit board in the power supply apparatus. The second flow channel cools the power module of the lower-layer circuit board. The first flow channel and the second flow channel are arranged in a flat manner, so that a heat dissipation path of the coolant in the power supply apparatus is longer. This effectively improves heat dissipation efficiency of the power supply apparatus, and further improves heat dissipation efficiency of the powertrain. In this way, vehicle performance is improved.

### BRIEF DESCRIPTION OF DRAWINGS

To describe technical solutions in embodiments of this application more clearly, the following describes accompanying drawings used in embodiments of this application.
FIG. 1 is a diagram of a structure of an electric vehicle according to an embodiment of this application;
FIG. 2A is a diagram of a structure of a powertrain according to an embodiment of this application;
FIG. 2B is a diagram of another structure of a powertrain according to an embodiment of this application;
FIG. 2C is a diagram of another structure of a powertrain according to an embodiment of this application;
FIG. 3 is a schematic exploded view of a powertrain according to an embodiment of this application;
FIG. 4 is a diagram of a structure of a power supply apparatus according to an embodiment of this application;
FIG. 5 is an exploded view of a power supply apparatus according to an embodiment of this application;
FIG. 6 is a diagram of another structure of a power supply apparatus according to an embodiment of this application;
FIG. 7 is another exploded view of a power supply apparatus according to an embodiment of this application;
FIG. 8 is another exploded view of a power supply apparatus according to an embodiment of this application;
FIG. 9 is another exploded view of a power supply apparatus according to an embodiment of this application;
FIG. 10 is a diagram of another structure of a power supply apparatus according to an embodiment of this application;
FIG. 11 is a diagram of a structure of an integrated groove housing according to an embodiment of this application;
FIG. 12 is a diagram of another structure of an integrated groove housing according to an embodiment of this application;
FIG. 13 is a bottom view of an integrated groove housing according to an embodiment of this application;
FIG. 14 is an AA cross sectional view of FIG. 13;
FIG. 15 is a diagram of a partial structure of an integrated groove housing according to an embodiment of this application; and
FIG. 16 is a diagram of structures of a first flow channel groove and a second flow channel groove according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

For ease of understanding, English abbreviations and related technical terms used in embodiments of this application are first explained and described below.

NVH: The NVH is short for noise, vibration, harshness.

DCDC: A DC is short for direct current. The DCDC represents an apparatus that converts a direct current power supply of a voltage level into a direct current power supply of another voltage level. The DCDC is classified into a boost power supply and a buck power supply based on a voltage level conversion relationship. For example, a DCDC converter connected to a vehicle-mounted power supply system converts a high voltage direct current into a low voltage direct current.

Parallel: This may be understood as basically parallel, and is not limited to absolute parallel or an included angle of 180 degrees. An included angle that is not absolutely parallel and that is less than or greater than 180 degrees due to factors such as assembly tolerance, design tolerance, and process tolerance is also basically parallel.

Vertical: This may be understood as basically vertical, and is not limited to absolute vertical intersection or an included angle of 90 degrees. An included angle that is not absolutely vertical intersection and that is less than or greater than 90 degrees due to factors such as assembly tolerance, design tolerance, and process tolerance is also basically vertical.

First direction, second direction, and third direction: The first direction is vertical to the second direction and the third direction, the second direction is vertical to the first direction and the third direction, the third direction is vertical to the first direction and the second direction, and the second direction is parallel to an axial direction of a powertrain or an axial direction of a motor.

To improve heat dissipation efficiency of a power supply apparatus and ensure stable running of the power supply apparatus, this application provides an all-in-one power supply apparatus. The power supply apparatus is configured to: charge and discharge a battery, and drive a motor. The power supply apparatus includes an integrated groove housing, a radiator, an upper-layer circuit board, and a lower-layer circuit board. The integrated groove housing includes a bottom plate, the bottom plate includes a first flow channel and a second flow channel, and the first flow channel is configured to communicate the second flow channel and the radiator. The first flow channel and the second flow channel are arranged in a first direction. The first flow channel, the upper-layer circuit board, and the radiator are sequentially stacked in a third direction, and the first flow channel and the radiator are configured to cool an electrical component in an on-board charger carried on the upper-layer circuit board. The second flow channel and the lower-layer circuit board are stacked in the third direction, and the second flow channel is configured to cool a power module of a motor control unit carried on a lower surface of the lower-layer circuit board. The upper-layer circuit board is stacked between the first flow channel and the radiator, and the upper-layer circuit board is cooled by a coolant in the first flow channel and the radiator, thereby improving heat dissipation efficiency of the power supply apparatus. The first flow channel and the second flow channel are arranged in a flat manner. In this way, a heat dissipation path for the coolant in the power supply apparatus is longer, thereby further improving heat dissipation efficiency of the power supply apparatus, and ensuring normal operating of the power supply apparatus.

The all-in-one power supply apparatus provided in embodiments of this application is used in an all-in-one powertrain, and the all-in-one powertrain is used in an electric vehicle, to improve overall performance of the electric vehicle.

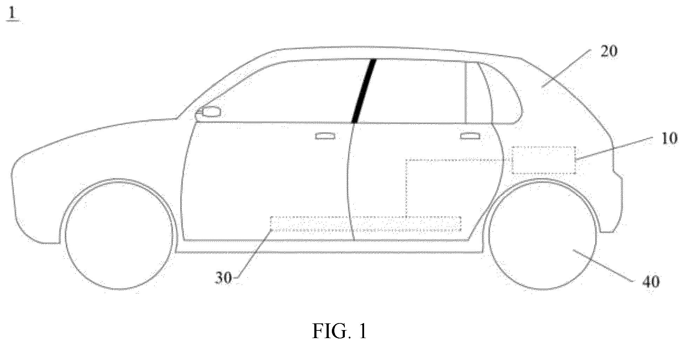

FIG. 1 is a diagram of a structure of an electric vehicle 1 according to an embodiment of this application.

As shown in FIG. 1, in this embodiment of this application, the electric vehicle 1 is a wheeled device driven or pulled by a power apparatus.

In this embodiment of this application, the electric vehicle 1 includes a powertrain 10, a vehicle frame 20, a battery 30, and wheels 40. The powertrain 10 and the battery 30 are fastened to the vehicle frame 20. The powertrain 10 is configured to receive power supplied by the battery 30, and is configured to drive the wheels 40. In this embodiment of this application, the battery 30 may also be referred to as a battery pack or a power battery. In this embodiment of this application, the powertrain 10 includes a motor 300, a reducer 200, and a power supply apparatus 100. In this embodiment of this application, the motor 300 includes a motor shaft, a motor stator, and a motor rotor. In this embodiment of this application, the reducer 200 is a single-level reduction gear assembly, a two-level reduction gear assembly, or a multi-level reduction gear assembly. The motor rotor in the motor 300 is fastened to and sleeved on the motor shaft. After receiving an alternating current, the motor stator drives the motor rotor to rotate, to drive the motor shaft to rotate. The motor shaft of the motor 300 is configured to be in transmission connection to the reducer 200. In an embodiment, the reducer 200 includes a gear assembly, an input shaft, a middle shaft, and an output shaft. The motor shaft of the motor 300 is configured to be in transmission connection to the input shaft of the reducer 200, and the input shaft is in transmission connection to the output shaft through the gear assembly and the middle shaft.

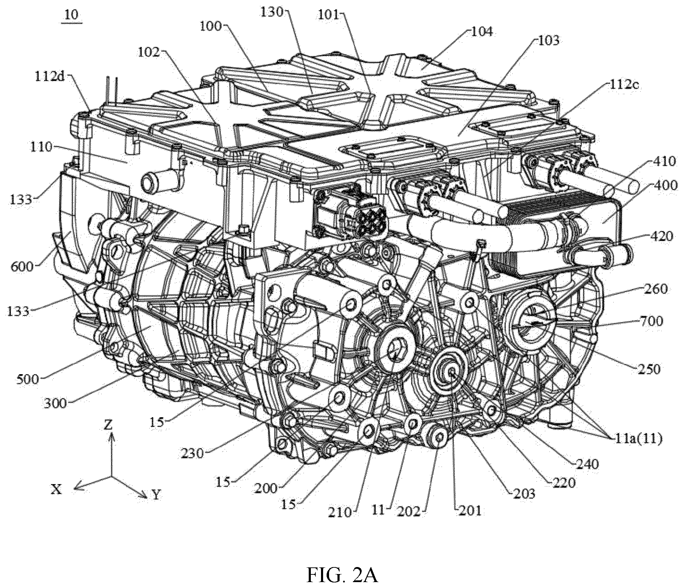

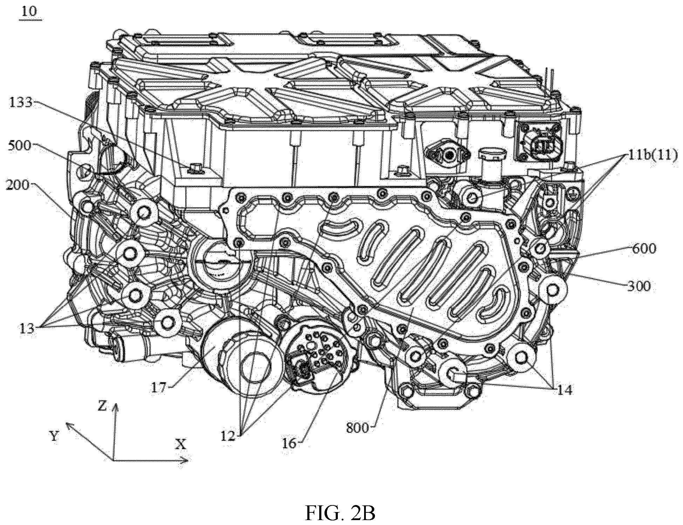

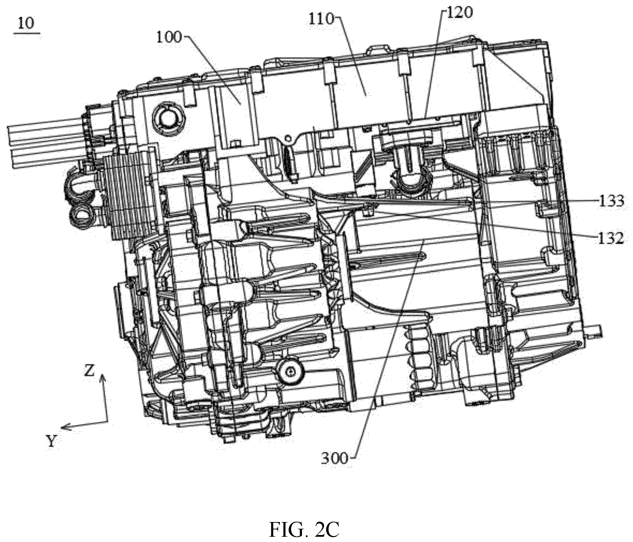

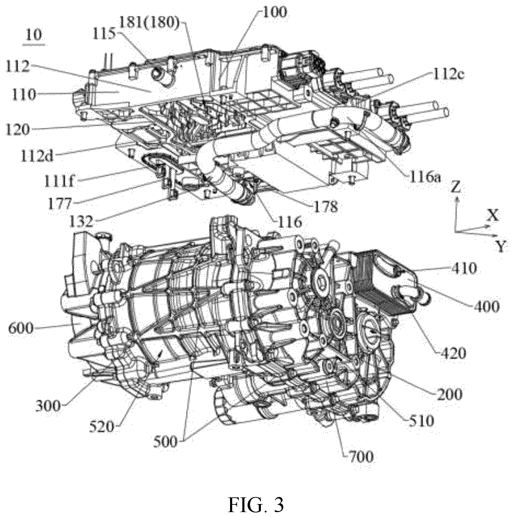

FIG. 2A is a diagram of a structure of the powertrain 10 according to an embodiment of this application. FIG. 2B is a diagram of another structure of the powertrain 10 according to an embodiment of this application. FIG. 2C is a diagram of another structure of the powertrain 10 according to an embodiment of this application. FIG. 3 is a schematic exploded view of the powertrain 10 according to an embodiment of this application.

As shown in FIG. 2A, the reducer 200 includes an input shaft 230, a middle shaft 240, and an output shaft 250. An input wheel is fastened to the input shaft 230, a middle wheel is fastened to the middle shaft 240, and an output wheel is fastened to the output shaft 250. The input shaft 230 is in transmission connection to the motor shaft. The input shaft 230 drives the input wheel of the reducer 200 to rotate, the input wheel drives the middle wheel to rotate, and then the middle wheel transmits power to the output wheel. In an embodiment, outer diameters of gears of the input wheel, the middle wheel, and the output wheel sequentially increase, and quantities of bevel teeth of outer rings of the input wheel, the middle wheel, and the output wheel gradually increase, to facilitate two-level deceleration and implement deceleration and torque increase. This better matches a power requirement of a vehicle.

As shown in FIG. 2A, the powertrain 10 further includes a heat exchanger 400. In this embodiment of this application, the motor 300 and the reducer 200 are cooled and lubricated by using cooling oil. The heat exchanger 400 is configured to cool the cooling oil.

In an embodiment, the heat exchanger 400 includes a liquid inlet 410 of the heat exchanger and a liquid outlet 420 of the heat exchanger. The liquid inlet 410 of the heat exchanger is configured to receive a coolant. The coolant exchanges heat with the cooling oil in the heat exchanger 400, to take away heat in the cooling oil with a high temperature. Then, the coolant flows out of the heat exchanger 400 from the liquid outlet 420 of the heat exchanger. In this way, the coolant cools the entire powertrain 10.

In this embodiment of this application, the heat exchanger 400 and the reducer 200 are stacked in a second direction Y, so that the heat exchanger 400 does not occupy a height of the powertrain 10 in a third direction Z, and a height of the powertrain 10 is small. This helps mount the powertrain 10 on the electric vehicle.

In this embodiment of this application, the power supply apparatus 100, the motor 300, and the reducer 200 may be of a split structure or an integrated structure. In an embodiment, the motor 300 and the power supply apparatus 100 share one housing. This helps reduce a volume of the powertrain 10, so that the powertrain 10 is more centralized. In an embodiment, the reducer 200 and the power supply apparatus 100 share one housing. This helps reduce the volume of the powertrain 10, so that the powertrain 10 is more centralized. In an embodiment, the motor 300, the reducer 200, and the power supply apparatus 100 share one housing. This helps reduce the volume of the powertrain 10, so that the powertrain 10 is more centralized.

In an embodiment, the motor 300 and the reducer 200 are of an integrated structure. As shown in FIG. 2A, the motor 300 and the reducer 200 share an integrated housing 500. The integrated housing 500 for the motor 300 and the reducer 200 and a housing of the power supply apparatus 100 are of a split structure. The housing of the power supply apparatus 100 is fastened above the integrated housing 500 of the motor 300 and the reducer 200.

In an embodiment, the housing of the powertrain 10 further includes a motor end cover 600 and a reducer end cover 700. As shown in FIG. 2A, in an axial direction of the motor 300, the integrated housing 500 is arranged between the motor end cover 600 and the reducer end cover 700. The integrated housing 500 and the motor end cover 600 are enclosed to form a motor accommodating cavity, and the integrated housing 500 and the reducer end cover 700 are enclosed to form a reducer accommodating cavity. The motor accommodating cavity is configured to fasten the stator of the motor 300 and accommodate the rotor of the motor 300, and the reducer accommodating cavity is configured to accommodate the gear assembly of the reducer 200.

In an embodiment, the reducer end cover 700 includes an input shaft bearing hole 210, a middle shaft bearing hole 220, and an output shaft bearing hole 260. As shown in FIG. 2A, the input shaft bearing hole 210 is configured to accommodate a bearing sleeved on the input shaft 230 of the reducer 200. The input shaft 230 of the reducer 200 is in transmission connection to the motor shaft of the motor 300. The middle shaft bearing hole 220 is configured to accommodate a bearing sleeved on the middle shaft 240 of the reducer 200. The output shaft bearing hole 260 is configured to accommodate a bearing sleeved on the output shaft 250 of the reducer 200.

In an embodiment, the reducer end cover 700 includes a plurality of compressor mounting bosses 11. The plurality of compressor mounting bosses 11 are configured to fasten a compressor. The plurality of compressor mounting bosses 11 are disposed on the reducer end cover 700, so that the compressor can be fastened to the powertrain 10, the powertrain 10 is integrated with the compressor, and the powertrain 10 is more integrated.

In an embodiment, the plurality of compressor mounting bosses 11a are distributed on peripheral sides of the input shaft bearing hole 210 and the middle shaft bearing hole 220. As shown in FIG. 2A, the plurality of compressor mounting bosses 11a are distributed on the peripheral sides of the input shaft bearing hole 210 and the middle shaft bearing hole 220, so that the compressor is mounted and arranged on an outer side of the reducer end cover 700 in the second direction Y Arrangement in the peripheral sides of the input shaft bearing hole 210 and the middle shaft bearing hole 220 can further enable a contact area between the compressor mounting boss 11a and the compressor to be large, so that the compressor is more securely mounted, and structural reliability is improved.

In an embodiment, the reducer end cover 700 further includes an oil filler plug 201 and an oil drain plug 202. As shown in FIG. 2A, the oil filler plug 201 is located at an axis center of the middle shaft 240 of the reducer 200, and the middle shaft 240 of the reducer 200 is a hollow shaft, to form an oil filler port of the powertrain 10 for delivery or maintenance. The oil drain plug 202 is located at a lowest point of the powertrain 10, and the oil drain plug 202 communicate with an oil stirring tank 203. The oil drain plug 202 may be used to drain oil in the powertrain 10, and replace the oil stored in the powertrain 10.

In an embodiment, the motor end cover 600 includes an annular fastening boss 12, and the annular fastening boss 12 is configured to fasten a resolver cover plate 800. As shown in FIG. 2B, the resolver cover plate 800, the motor end cover 600, and the annular fastening boss 12 are enclosed to form a motor wiring end accommodating cavity. In an embodiment, the motor wiring end accommodating cavity is configured to accommodate a resolver sensor of the motor 300. In an embodiment, the motor wiring end accommodating cavity is configured to accommodate a three-phase copper bar of the motor 300.

In an embodiment, the motor end cover 600 includes a plurality of compressor mounting bosses 11b, and the compressor mounting bosses 11b are configured to fasten the compressor. As shown in FIG. 2B, the plurality of compressor mounting bosses 11b are distributed on a peripheral side of the annular fastening boss 12. The compressor is mounted and fastened on an outer side of the resolver cover plate 800 in the second direction Y, and the plurality of compressor mounting bosses 11b are distributed on the periphery side of the annular fastening boss 12, so that the compressor is mounted more evenly, and the compressor is mounted more stably. This improves reliability of the structure.

In an embodiment, the resolver cover plate 800 is a damping cover plate, so that noise radiation can be effectively reduced, and NVH performance of the powertrain 10 can be improved.

As shown in FIG. 2B, in an embodiment, the integrated housing 500 includes a differential side suspension point 13, the motor end cover 600 includes a motor end cover side suspension point 14, and the reducer end cover 700 includes a reducer side suspension point 15 (as shown in FIG. 2A). The reducer 200 and the motor 300 are connected to a vehicle suspension and a bracket through the differential side suspension point 13, the motor end cover side suspension point 14, and the reducer side suspension point 15. The suspension is connected to a secondary vehicle frame, so that the powertrain 10 is mounted on the secondary frame of the vehicle.

As shown in FIG. 2B, the integrated housing 500 further includes an oil pump mounting hole 16 and a filter mounting hole 17. The oil pump mounting hole 16 is configured to mount an oil pump. The oil pump is configured to drive cooling oil to flow in the motor 300 and the reducer 200. The filter mounting hole 17 is configured to mount a filter, and the filter is used to filter impurities in the cooling oil.

As shown in FIG. 2A, FIG. 2B, and FIG. 2C, the integrated housing 500 further includes a plurality of power supply apparatus fastening points 133, and the plurality of power supply apparatus fastening points 133 are configured to fasten the integrated housing 500 to the housing of the power supply apparatus 100.

In an embodiment, the motor 300 and the reducer 200 are of the integrated structure. As shown in FIG. 3, the housings of the motor 300 and the reducer 200 and a housing of the power supply apparatus 100 are of the split structure, and the housing of the power supply apparatus 100 is fastened above the housings of the motor 300 and the reducer 200.

In an embodiment, the housing of the power supply apparatus 100 includes a liquid inlet 115 and a liquid outlet 116. As shown in FIG. 3, the liquid inlet 115 is configured to communicate with the liquid outlet 116 through an internal flow channel of the power supply apparatus 100. The liquid inlet 115 is configured to receive a coolant, and the liquid outlet 116 is configured to output the coolant through an external cooling pipe 116a. The external cooling pipe 116a is arranged between the housing of the power supply apparatus 100 and the integrated housing 500 of the motor 300 and the reducer 200. The external cooling pipe 116a is configured to communicate the liquid outlet 116 of the housing of the power supply apparatus 100 with the heat exchanger 400, in this way, so that the powertrain 10 is arranged more compactly.

In an embodiment, the housing of the power supply apparatus 100 includes a motor winding connector 177. As shown in FIG. 3, the motor winding connector 177 passes through the housing of the power supply apparatus 100, the housing of the motor 300, and the housing of the reducer 200. The power supply apparatus 100 outputs a three-phase alternating current through the motor winding connector 177 to drive the motor 300, so that the powertrain 10 is arranged more compactly.

Refer to FIG. 2C and FIG. 3. Two bolts 132 are disposed in a middle region of a lower surface of a bottom plate 120 of the power supply apparatus 100 and a middle region of the housing of the motor 300, to further fasten an integrated groove housing 110 to the housing of the motor 300. This helps reduce vibration amplitudes of the integrated groove housing 110 and the housing of the motor 300, improve a structural modality, reduce noise, and improve NVH performance of the powertrain 10.

In this embodiment of this application, the power supply apparatus 100 is configured to charge and discharge the battery 30 and drive the motor 300. The power supply apparatus 100 is configured to receive a direct current transmitted by the battery 30, convert the direct current into an alternating current, and transmit the alternating current to the motor 300. In addition, the power supply apparatus 100 is further configured to charge the battery 30. In an embodiment, the power supply apparatus 100 is configured to receive the alternating current and convert the alternating current into a direct current to charge the battery 30. The alternating current includes a mains power supply or a civil alternating current. In an embodiment, the power supply apparatus 100 receives a high voltage direct current and provides the direct current for charging the battery 30.

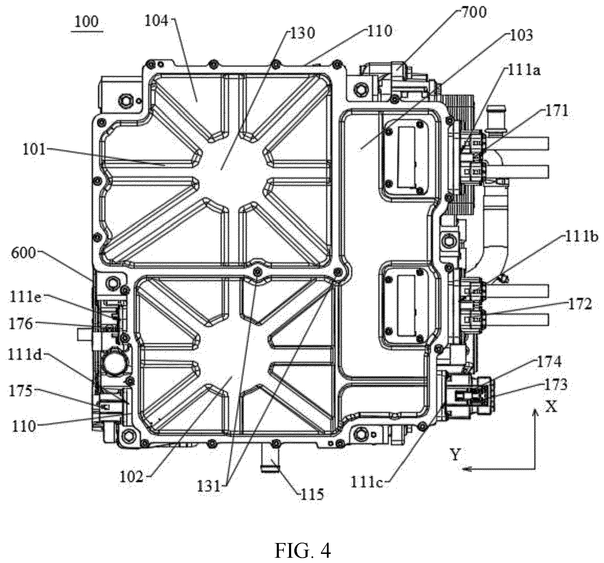

FIG. 4 is a diagram of a structure of a power supply apparatus 100 according to an embodiment of this application. As shown in FIG. 4, in an embodiment, the power supply apparatus 100 includes a motor control unit 101, an on-board charger 102, a power distribution unit 103, and a vehicle control unit 104.

A full name of the motor control unit 101 is motor control unit in English, and an English abbreviation is MCU. In an embodiment, the motor control unit 101 is configured to: receive a direct current of a power battery 30, convert the direct current into an alternating current, and transmit the alternating current to a stator winding of a motor 300, to drive the motor 300 to run.

An English name of the on-board charger 102 is on-board charger, and an English abbreviation is OBC. In an embodiment, the on-board charger 102 is configured to: convert an alternating current of a power grid into a direct current, or directly transmit the direct current to the power battery 30 for charging or supplying power to a load of the vehicle.

An English name of the power distribution unit 103 is power distribution unit, and an English abbreviation is PDU. In this embodiment of this application, the power distribution unit 103 is also referred to as a high voltage power distribution box. In an embodiment, the power distribution unit 103 is responsible for power distribution and management in a high voltage system of the electric vehicle 1, provides functions such as charging and discharging control, high voltage component power-on control, circuit overload and short-circuit protection, high voltage sampling, and low voltage control for the vehicle, and protects and monitors running of the high voltage system.

An English name of the vehicle control unit 104 is vehicle control unit, and an English abbreviation is VCU. In an embodiment, the vehicle control unit 104 is responsible for functions such as normal driving of the vehicle, braking energy feedback, fault diagnosis and processing of an energy pipeline of a vehicle drive system and the power battery 30 and a network pipeline, and vehicle status monitoring.

In an embodiment, the housing of the power supply apparatus 100 includes the integrated groove housing 110 and a cover plate 130. As shown in FIG. 4, the cover plate 130 and the integrated groove housing 110 are jointly enclosed to form an accommodating cavity 140. The accommodating cavity 140 is configured to accommodate a plurality of electrical components of each of the motor control unit 101, the on-board charger 102, the power distribution unit 103, and the vehicle control unit 104 in the power supply apparatus 100.

In an embodiment, the integrated groove housing 110 is further configured to fasten a plurality of connectors. As shown in FIG. 4, the plurality of connectors include a battery charge and discharge connector 171, a direct current power supply connector 172, a power supply connector 173, an alternating current power supply connector 175, a low voltage load connector 176, a motor winding connector 177 (as shown in FIG. 3), and a communication connector 178 (as shown in FIG. 3). In an embodiment, the integrated groove housing 110 further includes the liquid inlet 115 and the liquid outlet 116 (as shown in FIG. 3). The liquid inlet 115 is configured to communicate with the liquid outlet 116 through the internal flow channel of the integrated groove housing 110.

In an embodiment, the power supply apparatus 100 receives, through the battery charge and discharge connector 171, the direct current transmitted by the battery 30, converts the direct current into the alternating current, and transmits the alternating current to the stator winding of the motor 300 through the motor winding connector 177, to drive the rotor and the motor shaft of the motor 300 to rotate. The motor shaft rotates to drive the input shaft 230 of the reducer 200 to rotate. The input shaft 230 of the reducer 200 transmits power to an internal gear of the reducer 200. The output shaft 250 of the reducer 200 transmits power of the motor 300 to the wheels 40.

In an embodiment, the power supply apparatus 100 is connected to a direct current power supply through the direct current power supply connector 172 to charge the battery 30. The direct current power supply is configured to connect to the direct current power supply connector 172. The direct current power supply charges the battery 30 sequentially through the direct current power supply connector 172 in the power supply apparatus 100, the electrical component in the power distribution unit 103, and the battery charge and discharge connector 171. In an embodiment, the direct current power supply is a direct current charging pile.

In an embodiment, the power supply apparatus 100 is connected to an alternating current power supply through the alternating current power supply connector 175, to charge the battery 30. The alternating current power supply is configured to connect to the alternating current power supply connector 175. The alternating current power supply charges the battery 30 sequentially through the alternating current power supply connector 175 in the power supply apparatus, the electrical component in the on-board charger 102, and the battery charge and discharge connector 171. In an embodiment, the alternating current power supply is an alternating current charging pile or an alternating current power grid.

In an embodiment, the power supply apparatus 100 is connected to the compressor through the power supply connector 173 to supply power to the compressor. The compressor receives, through the power supply connector 173, the internal electrical component in the power supply apparatus 100, and the battery charge and discharge connector 171, a current provided by the battery 30. The compressor is a component in an air conditioner system in the vehicle, and cools or heats the vehicle.

In an embodiment, the power supply apparatus 100 is connected to a low voltage load through the low voltage load connector 176, to supply power to the low voltage load. The low voltage load connector 176 connects the low voltage load to the power supply apparatus 100. The low voltage load includes at least one of a low voltage battery, a vehicle lamp, a wiper, an air conditioner, a speaker, a USB interface, a dashboard, and a control display screen. In an embodiment, the low voltage battery may also supply power to another low voltage load. In an embodiment, the battery 30 sequentially supplies power to the low voltage load through the battery charge and discharge connector 171, the electrical component in the power supply apparatus 100, and the low voltage load connector 176.

In an embodiment, the communication connector 178 is connected to the vehicle control unit 104, and the communication connector 17 is configured to receive and send a signal.

In this embodiment of this application, the power supply apparatus 100 integrates the motor control unit 101, the on-board charger 102, the power distribution unit 103, and the vehicle control unit 104. The motor control unit 101, the on-board charger 102, the power distribution unit 103, and the vehicle control unit 104 respectively communicate with a plurality of external functional apparatuses through a plurality of connectors fastened by the integrated groove housing 110, to implement structural integration and functional integration of the power supply apparatus 100 and the powertrain 10.

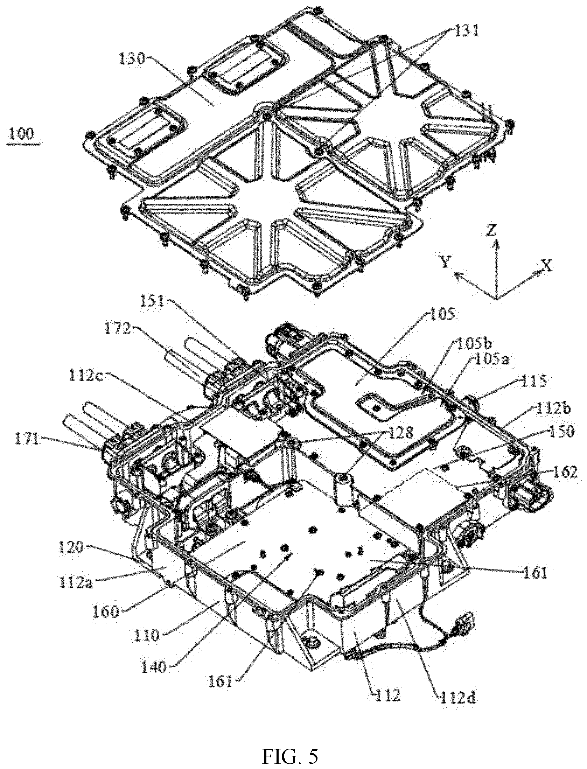

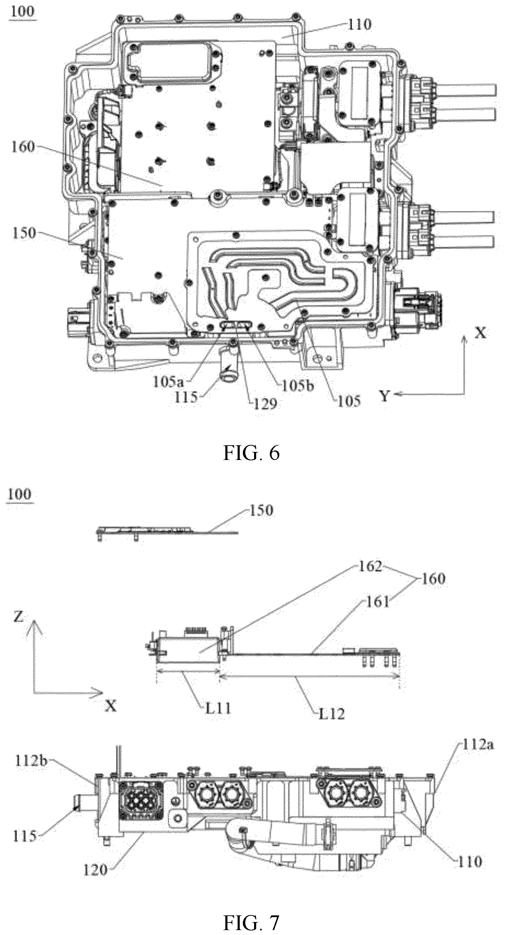

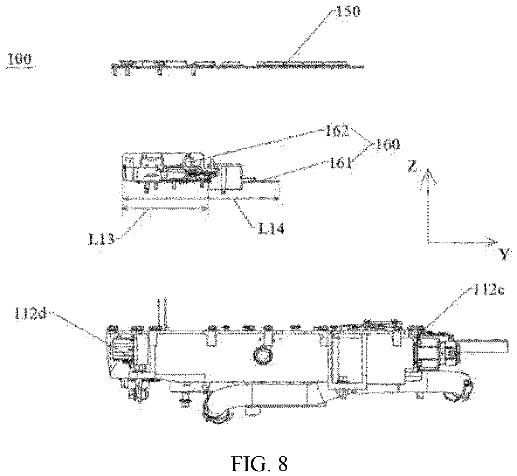

FIG. 5 is an exploded view of the power supply apparatus 100 according to an embodiment of this application. FIG. 6 is a diagram of another structure of the power supply apparatus 100 according to an embodiment of this application. FIG. 7 is another exploded view of the power supply apparatus 100 according to an embodiment of this application. FIG. 8 is another exploded view of the power supply apparatus 100 to an embodiment of this application.

As shown in FIG. 5, the power supply apparatus 100 includes the integrated groove housing 110 and the cover plate 130. The integrated groove housing 110 and the cover plate 130 are enclosed to form the accommodating cavity 140. The accommodating cavity 140 is configured to accommodate a motor control unit 101, an on-board charger 102, a power distribution unit 103, and a vehicle control unit 104. Eachincludes an electrical component that implements a function of the electrical component.

In an embodiment, the cover plate 130 is a damping cover plate. This helps reduce an amplitude of the cover plate 130 in an operating process of the power supplying apparatus 100, and helps improve a structural modality, reduce noise, and improve NVH performance of the power supplying apparatus 100.

In an embodiment, the cover plate 130 is detachably connected to the integrated groove housing 110. When an internal component in the power supply apparatus 100 needs to be repaired or replaced, a detachable connection relationship helps reduce operation difficulty and costs. In an embodiment, the detachable connection may be a screw connection.

As shown in FIG. 4 and FIG. 5, there are two bolts 131 in the middle of the cover plate 130, and the direct current power supply connector 172, the two bolts 131, and the low voltage load connector 176 are sequentially arranged in the second direction Y The cover plate 130 has a large surface area, and the bolts 131 are disposed at a middle location of the cover plate 130. This helps enhance mounting stability between the cover plate 130 and the integrated groove housing 110, can further reduce a vibration amplitude of the cover plate 130, and reduces noise generated by vibration of the cover plate 130 when the power supply apparatus 100 operates. This helps improve NVH performance of the vehicle.

In an embodiment, the power supply apparatus 100 includes the radiator 105, the upper-layer circuit board 150, and the lower-layer circuit board 160. As shown in FIG. 5 and FIG. 6, the accommodating cavity 140 is configured to accommodate the radiator 105, the upper-layer circuit board 150, and the lower-layer circuit board 160.

In an embodiment, the integrated groove housing 110 includes a bottom plate 120 and a peripheral side wall 112. As shown in FIG. 5 and FIG. 6, the bottom plate 120 and the peripheral side wall 112 are enclosed to form an accommodating groove. The cover plate 130, and the bottom plate 120 and the peripheral side wall 112 of the integrated groove housing 110 are enclosed to form the accommodating cavity 140.

In an embodiment, the peripheral side wall 112 of the integrated groove housing 110 includes a liquid inlet 115, and the bottom plate 120 of the integrated groove housing 110 includes a liquid outlet 116. Refer to FIG. 3, FIG. 4, and FIG. 5. The radiator 105 receives a coolant through the liquid inlet 115, and outputs the coolant through the liquid outlet 116.

In an embodiment, the bottom plate 120 of the integrated groove housing 110 includes an internal flow channel. The internal flow channel of the bottom plate 120 receives the coolant through the liquid inlet 115, and outputs the coolant through the liquid outlet 116. As shown in FIG. 5 and FIG. 6, the upper-layer circuit board 150 is sandwiched between the bottom plate 120 and the radiator 105, and the internal flow channel of the bottom plate 120 and the radiator 105 dissipate, by using the coolant, heat for an electrical component carried on the upper-layer circuit board 150, thereby improving heat dissipation efficiency, and improving cooling effect of the coolant on the power supply apparatus 100.

In an embodiment, the bottom plate 120, the lower-layer circuit board 160, the upper-layer circuit board 150, the radiator 105, and the cover plate 130 are sequentially stacked in the third direction Z. Refer to FIG. 5, FIG. 6, and FIG. 7, the bottom plate 120, the lower-layer circuit board 160, the upper-layer circuit board 150, the radiator 105, and the cover plate 130 are sequentially stacked, so that lengths of the integrated groove housing 110 in the first direction X and the second direction Y are small. This facilitates miniaturization of the power supply apparatus 100.

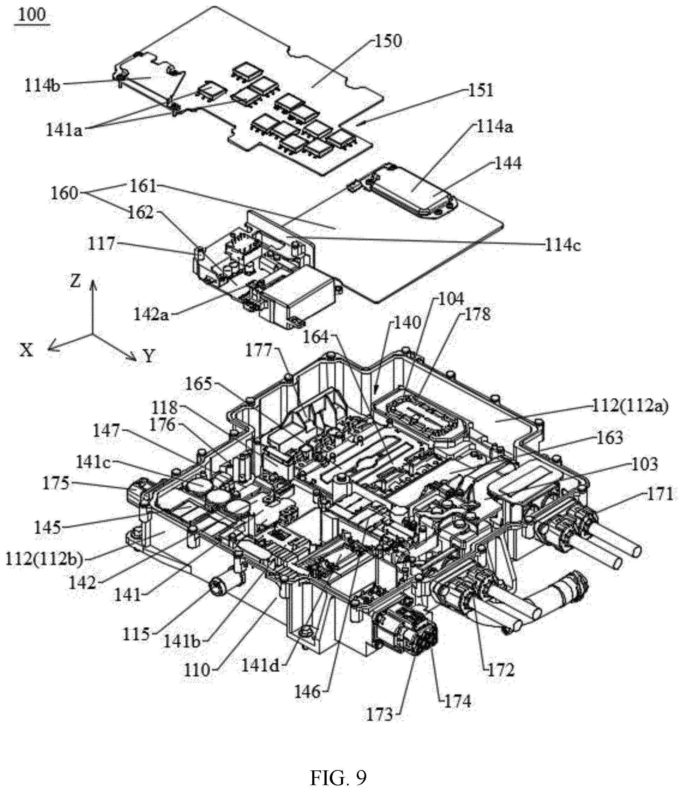

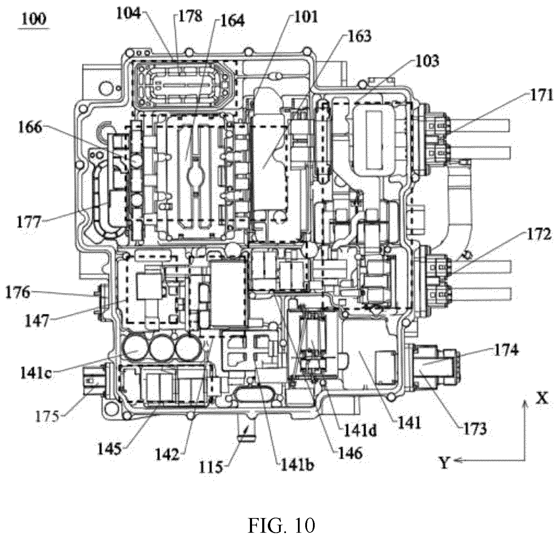

FIG. 9 is another exploded view of the power supply apparatus 100 according to an embodiment of this application. FIG. 10 is a diagram of another structure of the power supply apparatus 100 according to an embodiment of this application.

In an embodiment, a motor control unit 101 includes electrical components such as a bus capacitor 163, a power module 164, a Hall copper bar component 166, and a three-phase copper bar component 177. As shown in FIG. 9 and FIG. 10, the bus capacitor 163 is configured to smooth a bus voltage, so that the bus voltage of the motor control unit 101 is still smooth when a power switching transistor is turned on or off, can further reduce an inductance parameter of a line from a power switching transistor end of the motor control unit 101 to an end of the battery 30, to weak a peak voltage of the bus, can further absorb a high pulse current at a bus end of the motor control unit 101, and can further prevent overcharge of a voltage at the bus end and impact of an instantaneous voltage on the motor control unit 101.

In an embodiment, the bus capacitor 163, the power module 164, the Hall copper bar component 166, and the three-phase copper bar component 177 are sequentially arranged in the second direction Y As shown in FIG. 10, the bus capacitor 163 is connected to the battery charge and discharge connector 171 through a copper bar. The three-phase copper bar component 177 passes through one mounting hole 111f (as shown in FIG. 3), and the three-phase copper bar component 177 transmits an alternating current in the motor control unit 101 to the motor winding to drive the motor 300. In an embodiment, the three-phase copper bar component 177 is the motor winding connector 177. In this embodiment of this application, the electrical components in the motor control unit 101 are arranged in the second direction Y, so that power flow is smoother, and a power loss is reduced.

In an embodiment, the three-phase copper bar component 177, the power module 164, and the bus capacitor 163 are pre-mounted as a whole module through laser welding or screw fastening, and then are mounted in the power supply apparatus 100. This helps improve assembly and welding quality of the power supply apparatus 100.

In an embodiment, an on-board charger 141 is configured to connect the battery charge and discharge connector 171, the power supply connector 173, and the alternating current power supply connector 175. The on-board charger 102 includes the on-board charger 141 and a direct current converter 142. As shown in FIG. 9 and FIG. 10, the on-board charger 141 includes a power switching transistor 141a, an inductor 141b, and a capacitor 141c. The direct current converter 142 includes a power switching transistor 142a and a magnetic component. In this embodiment of this application, the magnetic component includes at least one of a capacitor and an inductor.

In an embodiment, the power distribution unit 103 includes a plurality of copper bars. As shown in FIG. 10, the power distribution unit 103 is configured to connect the direct current power supply connector 172 and the battery charge and discharge connector 171.

In an embodiment, the vehicle control unit 104 includes a plurality of chips 144. The vehicle control unit 104 is configured to connect to the communication connector 178. FIG. 9 shows a location of the chip 144.

In this embodiment of this application, the power supply apparatus 100 carries electrical components in the motor control unit 101, the on-board charger 141, the direct current converter 142, the power distribution unit 103, and the vehicle control unit 104 by using the upper-layer circuit board 150 and the lower-layer circuit board 160 that are stacked. In this way, functional circuits in the power supply apparatus 100 are deeply integrated and achieve higher integration.

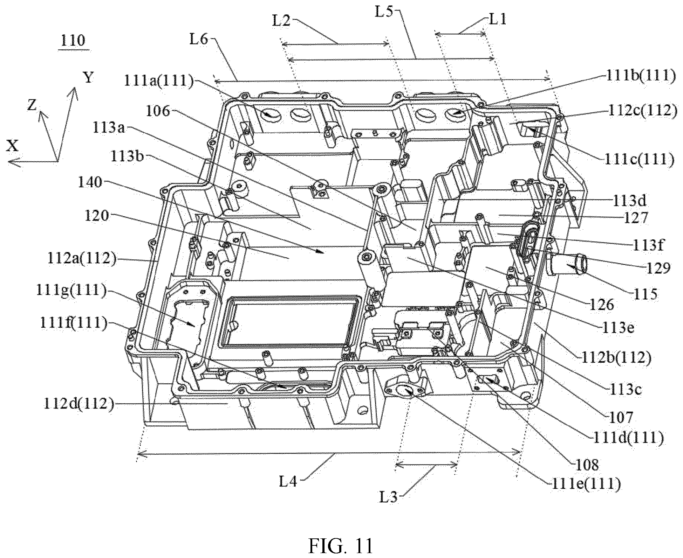

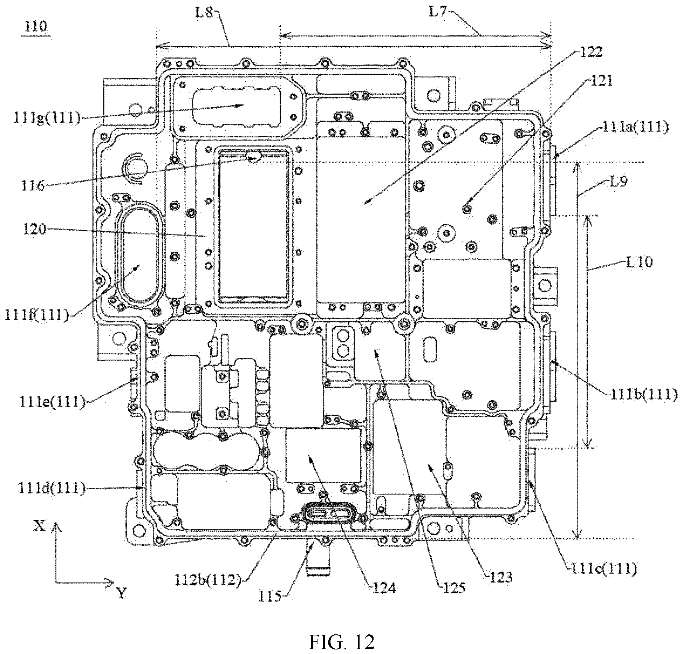

FIG. 11 is a diagram of a structure of the integrated groove housing 110 according to an embodiment of this application. FIG. 12 is a diagram of another structure of the integrated groove housing 110 according to an embodiment of this application.

In an embodiment, the integrated groove housing 110 includes a plurality of mounting holes 111, and the plurality of mounting holes 111 are configured to fasten connectors. As shown in FIG. 11 and FIG. 12, the integrated groove housing 110 includes the plurality of mounting holes 111. This helps mount a plurality of electrical components in the integrated groove housing 110, and helps electrically connect an external electrical component to the power supply apparatus 100, thereby improving integration of the power supply apparatus 100.

In an embodiment, the integrated groove housing 110 includes the bottom plate 120 and the peripheral side wall 112, and the bottom plate 120 and the peripheral side wall 112 are enclosed to form an accommodating groove.

As shown in FIG. 11, the peripheral side wall 112 of the integrated groove housing 110 includes a first side wall 112a, a second side wall 112b, a third side wall 112c, and a fourth side wall 112d. The first side wall 112a and the second side wall 112b are arranged opposite to each other in the first direction X. The third side wall 112c and the fourth side wall 112d are arranged opposite to each other in the second direction Y. The first side wall 112a, the third side wall 112c, the second side wall 112b, and the fourth side wall 112d are sequentially connected and enclosed to form the peripheral side wall 112 of the integrated groove housing 110. Three mounting holes 111a, 111b, and 111c penetrate the third side wall 112c in the second direction Y. Two mounting holes 111e and 111d penetrate the fourth side wall 112d in the second direction Y. The liquid inlet 115 is located on the second side wall 112b.

In an embodiment, the mounting holes 111a, 111b, and 111c are respectively used to fasten connectors 171, 172, and 173. As shown in FIG. 10 and FIG. 11, mounting holes 111d and 111e are respectively used to fasten connectors 175 and 176. Two bottom plate mounting holes 111f and 111g are respectively used to fasten a connector 177 and a connector 178.

In this embodiment of this application, the three mounting holes 111a, 111b, and 111c respectively include a battery charge and discharge connector mounting hole 111a, a direct current power supply connector mounting hole 111b, and a power supply connector mounting hole 111c. The battery charge and discharge connector mounting hole 111a, the direct current power supply connector mounting hole 111b, and the power supply connector mounting hole 111c are respectively configured to fasten the connectors 171, 172, and 173 that are of the power supply apparatus 100 and that are configured to connect the battery 30, the direct current power supply, and the compressor.

In this embodiment of this application, the two mounting holes 111d and 111e are respectively an alternating current power supply connector mounting hole 111d and a low voltage load connector mounting hole 111e. The alternating current power supply connector mounting hole 111d is configured to fasten the connector 175 that is of the power supply apparatus 100 and that is configured to connect to an alternating current power supply. The low voltage load connector mounting hole 111e is configured to fasten the connector 176 that is of the power supply apparatus 100 and that is configured to connect to a low voltage load. The connector 175 of the alternating current power supply is configured to connect to the alternating current power supply.

In this embodiment of this application, the two bottom plate mounting holes 111g and 111f are respectively a communication connector mounting hole 111g and a three-phase connector mounting hole 111f. The three-phase connector mounting hole 111f is configured to fasten the connector 177 that is of the power supply apparatus 100 and that is configured to connect to a motor winding. After converting a direct current in the battery 30 into an alternating current, the power supply apparatus 100 outputs the alternating current to the motor winding through the connector 177 connected to the motor winding, to drive the motor 300 to run. The communication connector mounting hole 111g is configured to fasten the vehicle control unit 104 in the power supply apparatus 100, and is configured to connect to the communication connector 178 of a vehicle-mounted load. The vehicle control unit 104 is configured to send a control signal to the power supply apparatus 100, to optimize energy distribution of the vehicle and running of the vehicle.

In this embodiment of this application, through a layout of the plurality of mounting holes 111, power flow is smoother, and a power loss is reduced, so that the connectors are electrically isolated from each other, crosstalk is avoided, and safety performance is improved. Through the layout of the plurality of mounting holes 111, a volume of the power supply apparatus 100 is small, and miniaturization of the powertrain 10 is facilitated.

As shown in FIG. 9, in an embodiment, the power supply connector mounting hole 111c is further configured to fasten the connector 174 that is of the power supply apparatus 100 and that is configured to connect to a heater.

In this embodiment of this application, the connector 174 of the heater is configured to connect to the heater (not shown in the figure). The heater is configured to heat the vehicle, and the heater is configured to heat a seat, including heating a front seat, a rear seat, or a middle seat. In some embodiments, when the electric vehicle 1 is a caravan, the heater may also heat a seat and a lying position in the caravan. In addition, after increasing a temperature of the vehicle, the heater may further perform defrosting and defogging.

In an embodiment, a housing of the connector 173 connected to the compressor and a housing of the connector 174 connected to the heater are integrated into an integrated structure. The connector 173 of the compressor and the connector 174 of the heater share one housing, so that integration of the power supply apparatus 100 is improved, and deep fusion of the power supply apparatus 100 and the powertrain 10 is facilitated. In addition, sharing one housing further helps reduce circuit arrangement in the power supply apparatus 100, saves materials, and reduces production costs.

In an embodiment, the bottom plate 120 of the integrated groove housing 110 further has a plurality of accommodating grooves. As shown in FIG. 12, the plurality of accommodating grooves are configured to accommodate a plurality of electrical components in the power supply apparatus 100.

In an embodiment, the plurality of accommodating grooves include a power distribution groove 121, a bus capacitor groove 122, a transformer groove 123, an inductor groove 124, and a direct current filter groove 125. As shown in FIG. 12, the power distribution groove 121 is configured to accommodate a copper bar of the power distribution unit 103. The bus capacitor groove 122 is configured to accommodate a bus capacitor 163 of the motor control unit 101. The transformer groove 123 is configured to accommodate a transformer 141d of the on-board charger 141. The inductor groove 124 is configured to accommodate a plurality of inductors 141b in the on-board charger 141. The direct current filter groove 125 is configured to accommodate a magnetic component in a direct current filter 146.

In this embodiment of this application, the plurality of accommodating grooves are formed on the bottom plate 120, so that the electrical components in the power supply apparatus 100 are arranged more regularly. This helps reduce internal space of the power supply apparatus 100, and helps reduce a volume of the power supply apparatus 100.

In an embodiment, the integrated groove housing 110 includes a plurality of shielding walls 113a, 113b, 113c, 113d, 113e and 113f. As shown in FIG. 11, a plurality of mounting regions are formed between the peripheral side wall 112 and the shielding wall or between the plurality of shielding walls, and the plurality of mounting regions are used to fasten and mount electrical components in the motor control unit 101, the on-board charger 141, the direct current converter 142, the vehicle control unit 104, and the power distribution unit 103.

The integrated groove housing 110 of the all-in-one power supply apparatus 100 provided in this embodiment of this application includes the plurality of mounting holes 111. With reference to FIG. 11 and FIG. 12, the three mounting holes 111a, 111b, and 111c are respectively used to fasten the connectors 171, 172, and 173 that are of the power supply apparatus 100 and that are configured to connect the battery 30, the direct current power supply (not shown in the figure), and the compressor (not shown in the figure).

As shown in FIG. 11 and FIG. 12, the three mounting holes 111a, 111b, and 111c penetrate the peripheral side wall 112 of the integrated groove housing 110 in the second direction Y. The three mounting holes 111a, 111b, and 111c are arranged on a same side of the integrated groove housing 110, and the three mounting holes 111a, 111b, and 111c are spaced in the first direction X. In this embodiment of this application, the power supply apparatus 100 integrates a function of charging and discharging the battery, a function of driving the motor, and a function of supplying power to the compressor. In addition, the connectors 171, 172, and 173 configured to connect the battery, the direct current power supply, and the compressor are fastened to the mounting hole 111 of the integrated groove housing 110 of the power supply apparatus 100, so that the power supply apparatus 100 has higher integration.

In an embodiment, the three mounting holes 111a, 111b, and 111c penetrate the peripheral side wall 112 of the integrated groove housing 110 in the second direction Y. In this way, when the connectors 171, 172, and 173 that connect the battery 30, the direct current power supply, and the compressor are connected to the electrical components in the power supply apparatus 100, no excessive cables are required. Connection lines between the power supply apparatus 100 and the battery 30, the direct current power supply, and the compressor are simplified, so that wiring of the electric vehicle is simpler.

In an embodiment, the three mounting holes 111a, 111b, and 111c penetrate the peripheral side wall 112 of the integrated groove housing 110 in the second direction Y, so that the connectors 171, 172, and 173 that connect the battery 30, the direct current power supply, and the compressor are arranged in the power supply apparatus 100 in the second direction Y. Space occupied by the power supply apparatus 100 in the first direction X and the third direction Z is reduced. This facilitates miniaturized arrangement and deep fusion of the power supply apparatus 100, and facilitates miniaturized arrangement of the powertrain 10.

In an embodiment, the three mounting holes 111a, 111b, and 111c are arranged on the same side of the integrated groove housing 110, so that the battery 30, the direct current power supply, and the connectors 171, 172, and 173 of the compressor can be integrated on the same side of the integrated groove housing 110 of the power supply apparatus 100. In this way, the power supply apparatus 100 has higher integration, and space occupied by the power supply apparatus 100 in the first direction X is reduced. Therefore, another connector or an electrical component may be mounted on another side surface of the integrated groove housing 110. This facilitates miniaturized arrangement and more diversified arrangement of the power supply apparatus 100 and the powertrain 10. The three mounting holes 111a, 111b, and 111c are spaced in the first direction X. This helps provide more space when the battery 30, the direct current power supply, and the connectors 171, 172, and 173 of the compressor are connected to the battery 30, the direct current power supply, and the compressor, and a layout is more appropriate.

In an embodiment, the three mounting holes 111a, 111b, and 111c are respectively the battery charge and discharge connector mounting hole 111a, the direct current power supply connector mounting hole 111b, and the power supply connector mounting hole 111c. As shown in FIG. 11, the power supply connector mounting hole 111c, the direct current power supply connector mounting hole 111b, and the battery charge and discharge connector mounting hole 111a are sequentially spaced in the first direction X.

In this embodiment of this application, the battery charge and discharge connector mounting hole 111a is configured to mount the connector 171 for arranging the battery 30. The battery 30 receives charging from the external power supply through the connector 171 of the battery 30 of the power supply apparatus 100. Alternatively, electric energy stored in the battery 30 may be released to the power supply apparatus 100 through the connector 171 of the battery 30, to provide a current for the electrical component in the power supply apparatus 100 to operate. The direct current power supply connector mounting hole 111b is configured to mount the direct current power supply connector 172. The direct current power supply connector 172 is connected to an external direct current power supply, to implement fast charging of the battery 30. In an embodiment, the direct current power supply is a direct current charging pile. The power supply connector mounting hole 111c is configured to mount a connector 173 for arranging a compressor. The compressor receives a current provided by the power supply apparatus 100. The compressor is a component in an air conditioner system in the vehicle, and cools or heats the vehicle.

In this embodiment of this application, the power supply connector mounting hole 111c, the direct current power supply connector mounting hole 111b, and the battery charge and discharge connector mounting hole 111a are arranged on the same side of the integrated groove housing 110. This helps improve integration of the integrated groove housing 110. The power supply connector mounting hole 111c, the direct current power supply connector mounting hole 111b, and the battery charge and discharge connector mounting hole 111a are sequentially spaced in the first direction X. Therefore, the connector 173 of the compressor, the connector 172 of the direct current power supply, and the connector 171 of the battery 30 are sequentially spaced in the first direction X. This helps arrange connection cables between the connectors 171, 172, and 173, the power battery 30, the direct current power supply, and the compressor be on a same side of the power supply apparatus 100, so that the connection cables are more regular, and a layout is more appropriate.

In this embodiment of this application, in the first direction X, the direct current power supply connector mounting hole 111b is closer to the battery charge and discharge connector mounting hole 111a than the power supply connector mounting hole 111c. This helps the direct current power supply charge the battery 30 in a shorter path, helps save materials, and reduces production costs.

As shown in FIG. 11, in the first direction X, a spacing between the power supply connector mounting hole 111c and the direct current power supply connector mounting hole 111b is less than a spacing between the direct current power supply connector mounting hole 111b and the battery charge and discharge connector mounting hole 111a.

In this embodiment of this application, in the first direction X, a spacing between the power supply connector mounting hole 111c and the direct current power supply connector mounting hole 111b is denoted as L1, in the first direction X, a spacing between the direct current power supply connector mounting hole 111b and the battery charge and discharge connector mounting hole 111a is denoted as L2, and L1 is small. This helps a layout between the connector 173 of the compressor and the connector 172 of the direct current power supply be more compact, helps reduce space occupation in the first direction X, and helps improve integration of the power supply apparatus 100.

In this embodiment of this application, L2 is large. This facilitates arrangement of the connector 172 of the direct current power supply and the connector 171 of the battery 30 on the integrated groove housing 110, and also helps provide sufficient space for arrangement of the copper bar in the power supply apparatus 100 required by the direct current power supply to charge the battery 30. A general direct current power supply transmits a high voltage direct current to the battery 30. The direct current power supply is electrically connected to the battery 30 through a wide copper bar. The copper bar is configured to transmit the high voltage direct current, and L2 is large. In this way, a distance between the connector 172 of the direct current power supply and the connector 171 of the battery 30 is large. In this way, there is sufficient space inside the integrated groove housing 110 for mounting a plurality of copper bars between the connector 172 of the direct current power supply and the connector 171 of the battery 30, and electrical insulation between the plurality of copper bars can be ensured.

In an embodiment, two mounting holes 111d and 111e of the plurality of mounting holes 111 are respectively configured to fasten the connectors 175 and 176 that are of the power supply apparatus 100 and that are configured to connect the alternating current power supply and the low voltage load. As shown in FIG. 10 and FIG. 11, the two mounting holes 111d and 111e penetrate the peripheral side wall 112 of the integrated groove housing 110 in the second direction Y. The two mounting holes 111e and 111d are arranged opposite to the three mounting holes 111a, 111b, and 111c in the second direction Y.

In this embodiment of this application, the two mounting holes 111d and 111e penetrate the peripheral side wall 112 of the integrated groove housing 110 in the second direction Y, so that the connectors 175 and 176 that connect the alternating current power supply and the low voltage load do not need to be connected to the electrical component in the power supply apparatus 100 through excessive cables. In this embodiment of this application, the two mounting holes 111e and 111d penetrate the peripheral side wall 112 of the integrated groove housing 110 in the second direction Y, so that the connectors 175 and 176 of the alternating current power supply and the low voltage load are disposed in the power supply apparatus 100 in the second direction Y In this case, space occupied by the power supply apparatus 100 in the first direction X and the third direction Z is reduced, to facilitate miniaturized arrangement of the powertrain 10.

In this embodiment of this application, the two mounting holes 111d and 111e are respectively the alternating current power supply connector mounting hole 111d and the low voltage load connector mounting hole 111e, and the two mounting holes 111d and 111e are arranged opposite to the three mounting holes 111a, 111b, and 111c in the second direction Y. In other words, the alternating current power supply connector mounting hole 111d and the low voltage load connector mounting hole 111e are arranged opposite to the battery charge and discharge connector mounting hole 111a, the direct current power supply connector mounting hole 111b, and the power supply connector mounting hole 111c in the second direction Y. This helps the plurality of mounting holes 111 of the power supply apparatus 100 be arranged in a regular manner, and a layout is appropriate. In addition, this further facilitates an overall arrangement layout of the plurality of mounting holes 111, reduces space occupied by the power supply apparatus 100 in the first direction X, improves integration of the power supply apparatus 100, and facilitates a miniaturized layout of the power supply apparatus 100.

In this embodiment of this application, the alternating current power supply connector mounting hole 111d and the direct current power supply connector mounting hole 111b are arranged opposite to each other in the second direction Y, so that the alternating current power supply and the direct current power supply supply power to the power supply apparatus 100 from different sides of the power supply apparatus 100. The alternating current power supply and the direct current power supply are electrically isolated, to avoid mutual electrical impact.

In an embodiment, a spacing between the two mounting holes 111e and 111d in the first direction X is less than half of a length of the integrated groove housing 110. As shown in FIG. 11, a spacing between two mounting holes 111a and 111c that are farthest from each other in the three mounting holes 111a, 111b, and 111c in the first direction X is greater than the half of the length of the integrated groove housing 110.

As shown in FIG. 10 and FIG. 11, the spacing between the two mounting holes 111e and 111d in the first direction X is denoted as L3, that is, a spacing between the alternating current power supply connector mounting hole 111d and the low voltage load connector mounting hole 111e in the first direction X is L3. The length of the integrated groove housing 110 in the first direction X is denoted as L4, and L3<0.5L4. Therefore, the alternating current power supply connector mounting hole 111d and the low voltage load connector mounting hole 111e are arranged more compactly. More arrangement space is provided for the motor control unit 101 and the vehicle control unit 104 that are of the power supply apparatus 100 and that are close to the alternating current power supply connector mounting hole 111d and the low voltage load connector mounting hole 111e in the first direction X.

As shown in FIG. 11, a spacing between two mounting holes 111a and 111c that are farthest from each other in the three mounting holes 111a, 111b, and 111c in the first direction X is denoted as L5. A length of the integrated groove housing 110 in the first direction X is denoted as L6. In the three mounting holes 111a, 111b, and 111c in the first direction X, two mounting holes 111a and 111c that are farthest from each other are the power supply connector mounting hole 111c and the battery charge and discharge connector mounting hole 111a, and L5<0.5L6. Therefore, more space is provided for arranging the connector 173 of the compressor and the connector 171 of the battery 30, so that space of the integrated groove housing 110 of the power supply apparatus 100 is fully utilized, and the three mounting holes 111a, 111b, and 111c of the power supply apparatus 100 are arranged more properly. In addition, the direct current power supply connector mounting hole 111b can be disposed between the power supply connector mounting hole 111c and the battery charge and discharge connector mounting hole 111a.

As shown in FIG. 10 and FIG. 11, one mounting hole 111 (111d) of the connector 175 for fastening and connecting to the alternating current power supply and one mounting hole 111 (111c) of the connector 173 for fastening and connecting to the compressor are arranged opposite to each other in the second direction Y. One mounting hole 111 (111e) of the connector 176 for fastening and connecting to the low voltage load and one mounting hole 111 (111b) of the connector 172 for fastening and connecting to the direct current power supply are arranged opposite to each other in the second direction Y.

In this embodiment of this application, the one mounting hole 111 of the connector 175 for fastening and connecting to the alternating current power supply is the alternating current power supply connector mounting hole 111d, and the one mounting hole 111 of the connector 173 for fastening and connecting to the compressor is the power supply connector mounting hole 111c. The alternating current power supply connector mounting hole 111d and the power supply connector mounting hole 111c are arranged opposite to each other in the second direction Y. This facilitates regular arrangement of the plurality of mounting holes 111 on the power supply apparatus 100.

In this embodiment of this application, the one mounting hole 111 of the connector 176 for fastening and connecting the low voltage load is the low voltage load connector mounting hole 111e, and the one mounting hole 111 of the connector 172 for fastening and connecting to the direct current power supply is the direct current power supply connector mounting hole 111b. The low voltage load connector mounting hole 111e and the direct current power supply connector mounting hole 111b are arranged opposite to each other in the second direction Y. This facilitates regular arrangement of the plurality of mounting holes 111 on the power supply apparatus 100.

In this embodiment of this application, the alternating current power supply connector mounting hole 111d and the power supply connector mounting hole 111c are arranged opposite to each other in the second direction Y. The low voltage load connector mounting hole 111e and the direct current power supply connector mounting hole 111b are arranged opposite to each other in the second direction Y. This helps a more compact layout of the mounting holes 111 on the integrated groove housing 110. The alternating current power supply connector mounting hole 111d, the power supply connector mounting hole 111c, the low voltage load connector mounting hole 111e, and the direct current power supply connector mounting hole 111b are centrally arranged on one side of the integrated groove housing 110 of the power supply apparatus 100. This helps provide sufficient space for an electrical component layout of the battery charge and discharge connector mounting hole 111a, the motor control unit 101, and the vehicle control unit 104, and can avoid electrical interference.

In an embodiment, two bottom plate mounting holes 111f and 111g in the plurality of mounting holes 111 are respectively configured to fasten the connector 177 that is of the power supply apparatus 100 and that is configured to connect to the motor winding and the communication connector 178 that is of the vehicle control unit 104 in the power supply apparatus 100 and that is configured to connect to the vehicle-mounted load. As shown in FIG. 10 and FIG. 11, the two bottom plate mounting holes 111g and 111f penetrate the bottom plate 120 of the integrated groove housing 110 in the third direction Z. In this embodiment of this application, the two bottom plate mounting holes 111f and 111g are respectively the three-phase connector mounting hole 111f and the communication connector mounting hole 111g, and the three-phase connector mounting hole 111f penetrates the bottom plate 120 of the integrated groove housing 110 in the third direction Z. This helps the connector 177 connected to the motor winding to be connected to the motor winding through a shorter line, and helps the power supply apparatus 100 output an alternating current to the motor winding through a shorter path with less power consumption, to drive the rotor and the motor shaft of the motor 300 to rotate. The three-phase connector mounting hole 111f penetrates the bottom plate 120 of the integrated groove housing 110 in the third direction Z, so that space below the power supply apparatus 100 in the third direction Z can be fully used. This facilitates a miniaturized layout of the power supply apparatus 100, implements a miniaturized layout of the powertrain 10, and optimizes a vehicle layout. The communication connector mounting hole 111g penetrates the bottom plate 120 of the integrated groove housing 110 in the third direction Z, so that a first shielding cover 114a on the vehicle control unit 104 and the communication connector mounting hole 111g are arranged in a stacked manner in the third direction Z. This further helps the power supply apparatus 100 connect to the communication device in the powertrain 10 in the third direction Z, and does not additionally occupy space of the powertrain 10 in the first direction X and the second direction Y This facilitates a miniaturized layout of the powertrain 10.

As shown in FIG. 10 and FIG. 11, in an embodiment, in the first direction X, one mounting hole 111a that is in the three mounting holes 111a, 111b, and 111c and that is used to fasten the connector 171 connected to the battery 30 is arranged between the two bottom plate mounting holes 111g and 111f.

In this embodiment of this application, one mounting hole 111a that is in the three mounting holes 111a, 111b, and 111c and that is configured to fasten the connector 171 connected to the battery 30 is the battery charge and discharge connector mounting hole 111a. In the first direction X, the battery charge and discharge connector mounting hole 111a is arranged between the three-phase connector mounting hole 111f and the communication connector mounting hole 111g. This helps the bus capacitor 163 and the power module 164 in the motor control unit 101 of the power supply apparatus 100 output a current in the battery 30 to the motor winding smoothly. A layout of the communication connector mounting hole 111g close to the peripheral side wall 112 of the integrated groove housing 110 facilitates arrangement of the power module 164 and the bus capacitor 163 in the motor control unit 101, and further facilitates connection between the vehicle control unit 104 and the communication device by using a shorter line. This helps save materials, and reduces production costs.

As shown in FIG. 10 and FIG. 12, in the second direction Y, a spacing between a bottom plate mounting hole 111g for fastening the vehicle control unit 104 (as shown in FIG. 4) in the power supply apparatus 100 and for connecting the communication connector 178 to the vehicle-mounted load and any one of the three mounting holes 111a, 111b, and 111c is less than a spacing between a bottom plate mounting hole 111f for fastening the power supply apparatus 100 and for connecting the connector 177 of the motor winding and any one of the three mounting holes 111a, 111b, and 111c.

As shown in FIG. 12, in the second direction Y, a spacing between the communication connector mounting hole 111g and any one of the three mounting holes 111a, 111b, and 111c is L7, in the second direction Y, a spacing between the three-phase connector mounting hole 111f and any one of the three mounting holes 111a, 111b, and 111c is L8, and L7<L8. L8 is large, so that sufficient space is provided for arranging the circuit board in the power supply apparatus 100. L7 is small, so that the communication connector 178 is close to the peripheral side wall 112 of the integrated groove housing 110. In this way, there is a sufficient region in the middle of the bottom plate 120 for fastening the electrical component in the power supply apparatus 100. In this embodiment of this application, L7 is small, so that the communication connector 178 is close to the peripheral side wall 112 of the integrated groove housing 110, and the communication connector 178 is isolated from another electrical component in the power supply apparatus 100. This avoids electric wire interference from another electrical component to the communication connector 178.

In an embodiment, the integrated groove housing 110 further includes the liquid inlet 115 and the liquid outlet 116. As shown in FIG. 12, the liquid inlet 115 and the liquid outlet 116 are communicated through an internal flow channel of the integrated groove housing 110. The liquid inlet 115 is located on the peripheral side wall 112 of the integrated groove housing 110, and the liquid outlet 116 is located on the bottom plate 120 of the integrated groove housing 110. An opening of the liquid inlet 115 faces an inner cavity that is in the first direction X and that faces away from the integrated groove housing 110. An opening of the liquid outlet 116 faces away from the inner cavity of the integrated groove housing 110 in the third direction Z. A spacing between the liquid inlet 115 and the liquid outlet 116 in the first direction X is greater than a spacing between two mounting holes 111a and 111c that are farthest from each other in the three mounting holes 111a, 111b, and 111c.

In this embodiment of this application, the integrated groove housing 110 further includes the liquid inlet 115 and the liquid outlet 116, to facilitate coolant flowing in the power supply apparatus 100. The liquid inlet 115 is configured to input the coolant from a vehicle cooling system, the liquid outlet 116 is configured to output the coolant obtained after the power supply apparatus 100 is cooled and heated, and the coolant sequentially flows through the liquid inlet 115, the internal flow channel of the integrated groove housing 110, and the liquid outlet 116. The liquid inlet 115 is located on the peripheral side wall 112 (112b) of the integrated groove housing 110, to facilitate arrangement of an external cooling pipe connected to the liquid inlet 115. The liquid outlet 116 is located on the bottom plate 120 of the integrated groove housing 110. This helps the heated coolant flow out of the power supply apparatus 100 in a gravity direction, and helps reduce a power loss.

In this embodiment of this application, the opening of the liquid inlet 115 faces away from the inner cavity of the integrated groove housing 110 in the first direction X, so that the liquid inlet 115 is connected to the external cooling pipe, and the coolant is input to the power supply apparatus 100 to cool the power supply apparatus 100. The opening of the liquid outlet 116 faces away from the inner cavity of the groove housing in the third direction Z, so that the coolant flows out of the power supply apparatus 100 from the liquid outlet 116 in the third direction Z by gravity. This also helps arrange the external cooling pipe 116a (as shown in FIG. 3) connected to the liquid outlet 116 in space downwards in the third direction Z of the powertrain 10, and helps reduce space occupied in the third direction Z and the second direction Y of the powertrain 10.

As shown in FIG. 12, a spacing between the liquid inlet 115 and the liquid outlet 116 in the first direction X is denoted as L9, and a spacing between two mounting holes 111a and 111c that are farthest from each other in the three mounting holes 111a, 111b, and 111c in the first direction X is denoted as L10. In other words, a spacing between the power supply connector mounting hole 111c and the battery charge and discharge connector mounting hole 111a in the first direction X is L10. In this embodiment of this application, L9>L10. This helps the coolant flow in the power supply apparatus 100 with a long path and long flow time, helps the coolant better cool the power supply apparatus 100, and improves cooling efficiency.

In an embodiment, the reducer end cover 700 is arranged on a same side as the three mounting holes 111a, 111b, and 111c. Refer to FIG. 4 and FIG. 11. The motor end cover 600 is arranged on a same side as the two mounting holes 111e and 111d in the plurality of mounting holes 111.

In this embodiment of this application, the connector 177 that is in the general three-phase connector mounting hole 111f and that is configured to connect to the motor winding is connected to the motor winding connector led out from the motor end cover 600. In this embodiment of this application, the motor end cover 600 is arranged on the same side as the two mounting holes 111e and 111d in the plurality of mounting holes 111, so that the connector 177 of the three-phase connector mounting hole 111f can be connected to the motor winding in the motor end cover 600 through a short path. The reducer end cover 700 is arranged on a same side as the three mounting holes 111a, 111b, and 111c, so that wiring is generally not performed on an outer side of the reducer end cover 700. The three mounting holes 111a, 111b, and 111c are arranged on a same side as the reducer end cover 700. In this way, the connector in the three mounting holes 111a, 111b, and 111c leads out from one side of the reducer end cover 700. Therefore, space on an outer side of the reducer end cover 700 is fully used, but space of the powertrain 10 in the first direction X is not excessively occupied. This further facilitates arrangement and normalization of the powertrain 10.

In an embodiment, the lower-layer circuit board 160 of the power supply apparatus 100 includes a primary region 161 and a secondary region 162, and the primary region 161 and the secondary region 162 are adjacently arranged in the first direction X. As shown in FIG. 7, FIG. 8, FIG. 9, and FIG. 10, the integrated groove housing 110 includes the bottom plate 120. The bottom plate 120, the secondary region 162 of the lower-layer circuit board 160, and the upper-layer circuit board 150 are sequentially stacked in the third direction Z. The primary region 161 and the upper-layer circuit board 150 are spaced in the third direction Z. The primary region 161 is configured to carry the bus capacitor 163 and the power module 164 of the motor control unit 101 and the plurality of chips 144 of the vehicle control unit 104. The secondary region 162 is configured to carry at least a part of power switching transistors 142a of the direct current converter 142. The upper-layer circuit board 150 is configured to carry the plurality of power switching transistors 141a, the plurality of inductors 141b, and the plurality of capacitors 141c in the on-board charger 141.

In this embodiment of this application, both the upper-layer circuit board 150 and the lower-layer circuit board 160 are fastened to the integrated groove housing 110, and are supported by the integrated groove housing 110, so that the upper-layer circuit board 150 and the lower-layer circuit board 160 are fastened to the integrated groove housing 110 with high stability. Overall structural strength of the power supply apparatus 100 is stronger, and electrical connection is stable. When an external environment exerts external force on the power supply apparatus 100, the upper-layer circuit board 150, the lower-layer circuit board 160, and the integrated groove housing 110 are not easily displaced relative to each other. This helps the power supply apparatus 100 operate in a stable state.

In this embodiment of this application, the lower-layer circuit board 160 includes the primary region 161 and the secondary region 162, and the primary region 161 and the secondary region 162 are adjacently arranged in the first direction X, so that the circuit components of the lower-layer circuit board 160 are arranged in the first direction X.

In this embodiment of this application, the bottom plate 120, the secondary region 162 of the lower-layer circuit board 160, and the upper-layer circuit board 150 are sequentially stacked in the third direction Z, so that the electronic components of the power supply apparatus 100 can be stacked in the third direction Z, and space occupied by the power supply apparatus 100 in the first direction X and the second direction Y can be reduced. The primary region 161 and the upper-layer circuit board 150 are spaced in the third direction Z, so that space that is in the first direction X and that is occupied when the upper-layer circuit board 150 and the lower-layer circuit board 160 are tiled can be reduced. A plurality of circuits such as the motor control unit 101, the vehicle control unit 104, the direct current converter 142, and the on-board charger 141 are integrated and arranged in smaller space, to facilitate a miniaturized layout of the power supply apparatus 100.

As shown in FIG. 9, the upper-layer circuit board 150 is configured to carry the plurality of power switching transistors 141a, the plurality of inductors 141b, and the plurality of capacitors 141c in the on-board charger 141, so that the on-board charger 141 is integrated into the upper-layer circuit board 150. The on-board charger 141 may convert an alternating current input by an external power supply into a direct current for charging the battery 30.

It should be noted that, to show a structure relationship more clearly, in FIG. 9 and FIG. 10, a lower surface of the lower-layer circuit board 160 is separated from an electrical component (for example, the bus capacitor 163 and the power module 164) carried on the lower-layer circuit board 160. After assembly, the electrical component on the lower surface of the lower-layer circuit board 160 is electrically connected to the lower-layer circuit board 160. In an embodiment, the bus capacitor 163 is plug-connected to the lower surface of the primary region 161. It should be understood that a lower surface of the upper-layer circuit board 150 is separated from an electrical component carried on the upper-layer circuit board 150. After assembly, the electrical component on the lower surface of the upper-layer circuit board 150 is electrically connected to the upper-layer circuit board 150.

In an embodiment, the integrated groove housing 110 further includes the first side wall 112a, the second side wall 112b, and a first shielding wall 113a. As shown in FIG. 10 and FIG. 11, an upper surface of the bottom plate 120 in the third direction Z is configured to fasten the first side wall 112a, the second side wall 112b, and the first shielding wall 113a. In the first direction X, the first side wall 112a, the first shielding wall 113a, and the second side wall 112b are sequentially spaced. Space between the first side wall 112a and the first shielding wall 113a is used to accommodate the primary region 161. Space between the first shielding wall 113a and the second side wall 112b is used to accommodate the upper-layer circuit board 150. In the first direction X, the secondary region 162 protrudes from the first shielding wall 113a towards the second side wall 112b in the first direction.

In this embodiment of this application, the first side wall 112a, the second side wall 112b, and the first shielding wall 113a are fastened to the upper surface of the bottom plate 120 of the integrated groove housing 110, and may be configured to support and fasten the upper-layer circuit board 150 and the lower-layer circuit board 160, to improve stability of the power supply apparatus 100. In the first direction X, the first side wall 112a, the first shielding wall 113a, and the second side wall 112b are sequentially spaced, so that the first shielding wall 113a isolates the electrical component in the power supply apparatus 100 in the first direction X, to implement electrical shielding on the electrical component in the power supply apparatus 100.

In this embodiment of this application, space between the first side wall 112a and the first shielding wall 113a is used to accommodate the primary region 161, and the first side wall 112a and the first shielding wall 113a form a mounting region of the motor control unit 101 and the vehicle control unit 104. Refer to FIG. 10 and FIG. 11. The first shielding wall 113a may reduce electrical interference caused by the electrical component carried on the upper-layer circuit board 150 to the bus capacitor 163 of the motor control unit 101 of the primary region 161, the power module 164, and the plurality of chips 144 of the vehicle control unit 104, to improve electromagnetic compatibility of the power supply apparatus 100.

In this embodiment of this application, space between the first shielding wall 113a and the second side wall 112b is used to accommodate the upper-layer circuit board 150, and the first shielding wall 113a and the second side wall 112b form a mounting region of the on-board charger 141. The first shielding wall 113a can reduce electrical interference caused by the motor control unit 101 and the vehicle control unit 104 of the lower-layer circuit board 160 to the electrical component carried by the upper-layer circuit board 150, to improve electromagnetic compatibility of the power supply apparatus 100.

Refer to FIG. 7, FIG. 9, and FIG. 11. In the first direction X, the secondary region 162 protrudes from the first shielding wall 113a towards the second side wall 112b. This helps the secondary region 162 be disposed below the upper-layer circuit board 150 in the third direction Z, improves space utilization of the power supply apparatus 100, and reduces space occupied by the power supply apparatus 100 in the first direction X.

Refer to FIG. 9, FIG. 10, and FIG. 11. In the first direction X, the primary region 161, the secondary region 162, and the second side wall 112b are sequentially arranged, and the secondary region 162 is spaced from the second side wall 112b. Space between the secondary region 162 and the second side wall 112b is used to accommodate the plurality of inductors 141b in the on-board charger 141.

As shown in FIG. 10, in the first direction X, the primary region 161, the secondary region 162, and the second side wall 112b are sequentially arranged, and the secondary region 162 is spaced apart from the second side wall 112b, to provide space for arranging the plurality of inductors 141b in the on-board charger 141 in the power supply apparatus 100.

In this embodiment of this application, the space between the secondary region 162 and the second side wall 112b is used to accommodate the plurality of inductors 141b in the on-board charger 141. This helps fully utilize space in the accommodating cavity 140 of the power supply apparatus 100, improve space utilization, and further improve a fusion degree of the power supply apparatus 100.

In an embodiment, the lower surface of the upper-layer circuit board 150 is configured to carry the plurality of capacitors 141c in the on-board charger 141 and a plurality of magnetic components of the alternating current filter 145. Refer to FIG. 9, FIG. 10, and FIG. 11. The integrated groove housing 110 further includes a third shielding wall 113c, and in the third direction Z, the upper surface of the bottom plate 120 is configured to fasten the third shielding wall 113c. In the first direction X, the secondary region 162, the third shielding wall 113c, and the second side wall 112b are sequentially spaced. Space between the secondary region 162 and the third shielding wall 113c is used to accommodate the plurality of capacitors 141c in the on-board charger 141. Space between the third shielding wall 113c and the second side wall 112b is used to accommodate the plurality of magnetic components in the alternating current filter 145.

In this embodiment of this application, the plurality of capacitors 141c in the on-board charger 141 and the plurality of magnetic components in the alternating current filter 145 are fastened to the bottom plate 120 of the integrated groove housing 110. Space between the upper-layer circuit board 150 and the bottom plate 120 is used to accommodate the plurality of capacitors 141c in the on-board charger 141 and the plurality of magnetic components in the alternating current filter 145. The third shielding wall 113c is fastened to the upper surface of the bottom plate 120 of the integrated groove housing 110, and the third shielding wall 113c may be configured to support the upper-layer circuit board 150. This helps improve fastening strength between the upper-layer circuit board 150 and the integrated groove housing 110.

In this embodiment of this application, in the first direction X, the secondary region 162, the third shielding wall 113c, and the second side wall 112b are sequentially spaced, so that the third shielding wall 113c isolates the electrical component in the power supply apparatus 100 in the first direction X, to implement electrical shielding on the electrical component in the power supply apparatus 100. The third shielding wall 113c may reduce electrical interference caused by the secondary region 162 to the plurality of magnetic components in the alternating current filter 145 between the third shielding wall 113c and the second side wall 112b in the first direction X, may reduce electrical interference caused by the electrical component between the third shielding wall 113c and the second side wall 112b to the direct current converter 142 in the secondary region 162, and improves electromagnetic compatibility of the power supply apparatus 100. The third shielding wall 113c and the second side wall 112b are spaced, to help provide mounting space for the plurality of magnetic components in the alternating current filter 145.

In this embodiment of this application, the space between the secondary region 162 and the third shielding wall 113c is used to accommodate the plurality of capacitors 141c in the on-board charger 141. This helps fully use space of the lower surface of the upper-layer circuit board 150, and improve integration of the power supply apparatus 100.

In this embodiment of this application, the space between the third shielding wall 113c and the second side wall 112b is used to accommodate the plurality of magnetic components in the alternating current filter 145. The alternating current filter 145 includes an alternating current filter, and the alternating current filter is configured to filter out a harmonic in an alternating current.

Refer to FIG. 9, FIG. 10, and FIG. 11. In the second direction Y, the alternating current input connector mounting hole 111d is located between the third shielding wall 113c and the second side wall 112b (as shown in FIG. 11). In this way, an alternating current input from the connector 175 in the alternating current input mounting hole 111d can be directly filtered by the alternating current filter 145 between the third shielding wall 113c and the second side wall 112b. This reduces a line path and reduces a loss.

In an embodiment, the lower surface of the upper-layer circuit board 150 is configured to carry the plurality of inductors 141b in the on-board charger 141 and the plurality of magnetic components in the direct current filter 146. Refer to FIG. 9, FIG. 10, and FIG. 11. The integrated groove housing 110 further includes a fourth shielding wall 113d, and in the third direction Z, the upper surface of the bottom plate 120 is configured to fasten the fourth shielding wall 113d. In the first direction X, the first shielding wall 113a, the fourth shielding wall 113d, and the second side wall 112b are sequentially spaced. Space between the fourth shielding wall 113d and the first shielding wall 113a is used to accommodate the plurality of magnetic components in the direct current filter 146. Space between the fourth shielding wall 113d and the second side wall 112b is used to accommodate the plurality of inductors 141b in the on-board charger 141.

In this embodiment of this application, the plurality of inductors 141b in the on-board charger 141 and the plurality of magnetic components in the direct current filter 146 are arranged in the second direction Y, and the direct current filter 146 is configured to filter out a harmonic in a high voltage direct current. The fourth shielding wall 113d is configured to support the upper-layer circuit board 150, to enhance mounting stability of the upper-layer circuit board 150 and the integrated groove housing 110, and improve electrical connection stability of the power supply apparatus 100, so that the power supply apparatus 100 runs stably.

In this embodiment of this application, the first shielding wall 113a, the fourth shielding wall 113d, and the second side wall 112b are sequentially spaced in the first direction X, so that the circuit in the power supply apparatus 100 is divided more carefully. This helps reduce electrical interference between modules on the power supply apparatus 100, improve electromagnetic compatibility of the power supply apparatus 100, and ensure normal running of the power supply apparatus 100.

In this embodiment of this application, mounting space of the plurality of magnetic components in the direct current filter 146 is provided between the first shielding wall 113a and the fourth shielding wall 113d, and the plurality of inductors 141b in the on-board charger 141 are provided between the fourth shielding wall 113d and the second side wall 112b. The fourth shielding wall 113d helps reduce electrical interference caused by the plurality of magnetic components in the direct current filter 146 to the plurality of inductors 141b in the on-board charger 141, and further helps reduce interference caused by the plurality of inductors 141b in the on-board charger 141 to the plurality of magnetic components in the direct current filter 146. This facilitates stable running of the power supply apparatus 100.

Refer to FIG. 9, FIG. 10, and FIG. 11. The direct current input connector mounting hole 111b corresponds to the space between the first shielding wall 113a and the fourth shielding wall 113d. In this way, the direct current input through the direct current input mounting hole 111b can be filtered by the direct current filter 146 between the first shielding wall 113a and the fourth shielding wall 113d, to reduce a line path and reduce a loss.

Refer to FIG. 9, FIG. 10, and FIG. 11. The power supply connector mounting hole 111c corresponds to a region between the fourth shielding wall 113d and the second side wall 112b, so that the power supply connector 173 fastened by the power supply connector mounting hole 111c can be shielded by the fourth shielding wall 113b, to improve electromagnetic compatibility of the power supply apparatus 100.

In an embodiment, the integrated groove housing 110 further includes a fifth shielding wall 113e, and in the third direction Z, the upper surface of the bottom plate 120 is configured to fasten the fifth shielding wall 113e. Refer to FIG. 9, FIG. 10, and FIG. 11. The fifth shielding wall 113e and the secondary region 162 are spaced in the second direction Y. Space between the fifth shielding wall 113e and the secondary region 162 is used to accommodate the plurality of magnetic components in the direct current converter 142. A region enclosed by the fifth shielding wall 113e, the fourth shielding wall 113d, and the first shielding wall 113a is configured to accommodate the plurality of magnetic components in the direct current filter 146.

In this embodiment of this application, the fifth shielding wall 113e is configured to support the upper-layer circuit board 150. This helps enhance mounting stability between the upper-layer circuit board 150 and the integrated groove housing 110, and helps improve electrical connection stability of the power supply apparatus 100, so that the power supply apparatus 100 runs stably.

In this embodiment of this application, in the second direction Y, the fifth shielding wall 113e and the secondary region 162 are spaced, to help provide a mounting region for the plurality of magnetic components in the direct current to direct current converter 142. The space between the fifth shielding wall 113e and the secondary region 162 is used to accommodate the plurality of magnetic components in the direct current converter 142, so that when a high voltage current is converted into a low voltage direct current through the plurality of magnetic components in the direct current converter 142, the high voltage current can be converted into another current with a smaller voltage and transmitted to the low voltage load for power supply.

In this embodiment of this application, the plurality of magnetic components in the direct current filter 146 are accommodated in the region jointly enclosed by the fifth shielding wall 113e, the fourth shielding wall 113d, and the first shielding wall 113a. This helps reduce electrical interference caused by the motor control unit 101 circuit in the primary region 161 of the lower-layer circuit board 160, the direct current converter 142 of the upper-layer circuit board 150, and the transformer 141d to the direct current filter 146, so that the direct current filter 146 operates normally, and electromagnetic compatibility of the power supply apparatus 100 is improved.

In an embodiment, the integrated groove housing 110 further includes a sixth shielding wall 113f, in the third direction Z, the upper surface of the bottom plate 120 is configured to fasten the sixth shielding wall 113f, and the sixth shielding wall 113f extends in the first direction X. Refer to FIG. 9, FIG. 10, and FIG. 11. The fourth shielding wall 113d, the sixth shielding wall 113f, and the second side wall 112b are sequentially arranged in the first direction X. In the second direction Y, the secondary region 162, the fifth shielding wall 113e, and the sixth shielding wall 113f are sequentially spaced. The sixth shielding wall 113f is configured to separate the space between the fourth shielding wall 113d and the second side wall 112b into two regions 126, 127 arranged in the second direction Y. In the two regions 126 and 127, one region 126 closer to the secondary region 162 is configured to accommodate the plurality of inductors 141b in the on-board charger 141, and the other region 127 is configured to accommodate the transformer 141d of the on-board charger 141 and the compressor power supply connector 173.

In this embodiment of this application, in the third direction Z, the upper surface of the bottom plate 120 is configured to fasten the sixth shielding wall 113f, the sixth shielding wall 113f extends in the third direction Z, and the sixth shielding wall 113f may be configured to support the upper-layer circuit board 150. This helps enhance mounting stability between the upper-layer circuit board 150 and the integrated groove housing 110, and helps improve electrical connection stability of the power supply apparatus 100, so that the power supply apparatus 100 runs stably.

In this embodiment of this application, in the first direction X, the fourth shielding wall 113d, the sixth shielding wall 113f, and the second side wall 112b are sequentially spaced. The fourth shielding wall 113d may electrically shield the direct current filter 146 from the transformer 141d and the plurality of inductors 141b in the on-board charger 141. The sixth shielding wall 113f is disposed between the fourth shielding wall 113d and the second side wall 112b, and a length direction of the sixth shielding wall 113f is parallel to the first direction X, so that the transformer 141d arranged in the second direction Y and the plurality of inductors 141b in the on-board charger 141 are electrically shielded. This helps reduce electrical interference between the direct current filter 146, the transformer 141d, and the plurality of inductors 141b in the on-board charger 141, so that these modules run more smoothly.

In this embodiment of this application, in the second direction Y, the secondary region 162, the fifth shielding wall 113e, and the sixth shielding wall 113f are sequentially spaced. In the second direction Y, the secondary region 162 and the fifth shielding wall 113e are spaced to provide a mounting region for the direct current converter 142. The fifth shielding wall 113e and the sixth shielding wall 113f are spaced. Therefore, more mounting space is provided for mounting regions of the plurality of magnetic components in the alternating current filter 145 between the plurality of capacitors 141c in the on-board charger 141 and the sixth shielding wall 113f.

In this embodiment of this application, the sixth shielding wall 113f is configured to separate the space between the fourth shielding wall 113d and the second side wall 112b into the two regions 126 and 127 arranged in the second direction Y. This helps electrically shield the plurality of inductors 141b in the on-board charger 141 from the transformer 141d. The region 126 that is in the two regions 126 and 127 and that is closer to the secondary region 162 is used to accommodate the plurality of inductors 141b in the on-board charger 141. The other region 127 is configured to accommodate the transformer 141d of the on-board charger 141 and the compressor power supply connector 173. In other words, the sixth shielding wall 113f may reduce electrical interference caused by the plurality of inductors 141b in the on-board charger 141 to the transformer 141d of the on-board charger 141 and the compressor power supply connector 173, and may reduce electrical interference caused by the transformer 141d of the on-board charger 141 and the power supply connector 173 of the compressor to the plurality of inductors 141b in the on-board charger 141. This improves electromagnetic compatibility of the power supply apparatus 100, and ensures stable running of the power supply apparatus 100.

In an embodiment, the power supply apparatus 100 further includes the first shielding cover 114a, and the first shielding cover 114a is configured to shield at least a part of the plurality of chips 144 of the vehicle control unit 104. Refer to FIG. 9, FIG. 10, and FIG. 11. The bottom plate 120, the lower-layer circuit board 160, and the first shielding case 114a are sequentially stacked in the third direction Z. In the first direction X, the first side wall 112a and the first shielding case 114a are adjacently arranged.

In this embodiment of this application, the first shielding cover 114a is fastened and connected to at least a part of the plurality of chips 144 of the vehicle control unit 104. This helps enhance stability of the vehicle control unit 104 in the power supply apparatus 100. The first shielding cover 114a may shield electrical impact of the motor control unit 101 of the lower-layer circuit board 160 on the vehicle control unit 104, to improve electromagnetic compatibility of the power supply apparatus 100, so that communication of the vehicle control unit 104 (as shown in FIG. 4) operates smoothly.

In this embodiment of this application, the bottom plate 120, the lower-layer circuit board 160, and the first shielding cover 114a are sequentially stacked in the third direction Z. In other words, at least a plurality of chips 144 of the vehicle control unit 104 are in contact with the lower-layer circuit board 160. This facilitates a control signal of the vehicle control unit 104 to be transmitted from the communication connector 178 mounted at the communication connector mounting hole 111g to the chip 144 of the vehicle control unit 104, and then transmitted to the lower-layer circuit board 160 to control the power supply apparatus 100.

In this embodiment of this application, in the first direction X, the first side wall 112a and the first shielding cover 114a are arranged adjacent to each other, so that the communication connector mounting hole 111g is disposed close to the first side wall 112a. This helps the communication connector 178 to be electrically connected to the load on the vehicle.

In an embodiment, the power supply apparatus 100 further includes the second shielding cover 114b, and the second shielding cover 114b is configured to shield the plurality of magnetic components in the alternating current filter 145. Refer to FIG. 9, FIG. 10, and FIG. 11. The bottom plate 120, the upper-layer circuit board 150, and the second shielding case 114b are sequentially stacked in the third direction Z. In the first direction X, the second side wall 112b, the second shielding case 114b, and the third shielding wall 113c are adjacently arranged.

In this embodiment of this application, the second shielding case 114b is fastened and connected to the third shielding wall 113c and the second side wall 112b, so that structural stability of the power supply apparatus 100 can be enhanced. In addition, a region enclosed by the third shielding wall 113c, the second shielding case 114b, and the second side wall 112b is used to mount the plurality of magnetic components in the alternating current filter 145. This helps reduce electrical interference caused by the plurality of capacitors 141c and the plurality of inductors 141b in the on-board charger 141 to the plurality of magnetic components in the alternating current filter 145.

Refer to FIG. 9, FIG. 10, and FIG. 11. The secondary region 162 is further configured to carry the plurality of magnetic components in the low voltage filter 147, and the space between the secondary region 162 and the upper-layer circuit board 150 is used to accommodate the plurality of magnetic components in the low voltage filter 147.

In this embodiment of this application, the secondary region 162 not only carries at least a part of the power switching transistors 142a of the direct current converter 142, but also carries the plurality of magnetic components in the low voltage filter 147. This helps integrate the direct current converter 142 and the low voltage filter 147 into the lower-layer circuit board 160, so that the bus capacitor 163 and the power module 164 of the vehicle control unit 104, the plurality of chips 144 of the vehicle control unit 104, the direct current converter 142, and the low voltage filter 147 share one lower-layer circuit board 160. This helps reduce a quantity of used circuit boards, and helps improve integration of the power supply apparatus 100.

In this embodiment of this application, the space between the secondary region 162 and the upper-layer circuit board 150 is used to accommodate the plurality of magnetic components in the low voltage filter 147. This helps improve space utilization inside the power supply apparatus 100, and improve a fusion degree between modules in the power supply apparatus 100.

In an embodiment, the power supply apparatus 100 further includes a third shielding cover 114c and a 12 V copper bar 117. Refer to FIG. 9, FIG. 10, and FIG. 11. In the first direction X, the primary region 161, the third shielding cover 114c, and the secondary region 162 are sequentially arranged adjacent to each other.

In this embodiment of this application, the third shielding cover 114c is a 12 V shielding cover, and the third shielding cover 114c extends in the second direction Y and is vertical to the lower-layer circuit board 160. This helps provide support for the cover plate 130 of the power supply apparatus 100, and helps improve mounting stability of the power supply apparatus 100. In the first direction X, the third shielding cover 114c is located between the primary region 161 and the secondary region 162 of the lower-layer circuit board 160, so that electrical interference between the primary region 161 and the secondary region 162 can be reduced. The third shielding cover 114c is configured to shield the plurality of magnetic components in the low voltage filter 147. The 12 V copper bar 117 is configured to transmit a current in the low voltage filter 147 to the low voltage load. A shielding area of the low voltage filter 147 is formed between the third shielding case 114c and the third shielding wall 113c, to facilitate smooth running of the low voltage filter 147.

In an embodiment, the power supply apparatus 100 further includes a board-to-board connector 118 that connects the upper-layer circuit board 150 and the lower-layer circuit board 160. Refer to FIG. 9, FIG. 10, and FIG. 11. The board-to-board connector 118 is used to implement a communication connection between the upper-layer circuit board 150 and the lower-layer circuit board 160. This helps connect the upper-layer circuit board 150 and the lower-layer circuit board 160, and promotes deep fusion of the power supply apparatus 100. In addition, the power supply apparatus 100 further has many slotting tool structures, and is configured to electrically connect the upper-layer circuit board 150 and the lower-layer circuit board 160.

Refer to FIG. 9, FIG. 10, and FIG. 11. Upper surfaces of the third shielding wall 113c, the fourth shielding wall 113d, the fifth shielding wall 113e, and the sixth shielding wall 113f in the third direction Z are attached to the lower surface of the upper-layer circuit board 150. This helps implement better shielding effect of the circuit in the upper-layer circuit board 150.

In an embodiment, the integrated groove housing 110 further includes the third side wall 112c, the second shielding wall 113b, and the fourth side wall 112d. The upper surface of the bottom plate 120 in the third direction Z is configured to fasten the third side wall 112c, the second shielding wall 113b, and the fourth side wall 112d. Refer to FIG. 9, FIG. 10, and FIG. 11. The third side wall 112c, the second shielding wall 113b, and the fourth side wall 112d are sequentially spaced in the second direction Y. Space between the third side wall 112c and the second shielding wall 113b is used to accommodate a part of copper bars of the power distribution unit 103. Space between the second shielding wall 113b and the fourth side wall 112d is used to accommodate the primary region 161.

As shown in FIG. 4, the first side wall 112a, the second side wall 112b, the third side wall 112c, the fourth side wall 112d, the bottom plate 120, and the cover plate 130 jointly enclose the accommodating cavity 140 of the integrated groove housing 110. The accommodating cavity 140 is configured to accommodate the upper-layer circuit board 150 and the lower-layer circuit board 160.

In this embodiment of this application, the second shielding wall 113b is fastened to the upper surface of the bottom plate 120 in the third direction Z, and the second shielding wall 113b has a support function for the power supply apparatus 100. This helps improve mounting stability of the power supply apparatus 100, and ensures stable running of the power supply apparatus 100.

In this embodiment of this application, the power distribution unit 103 converts a high voltage direct current output by the battery 30 into a direct current voltage or an alternating current required by a load when the load operates, to supply power to the load. In the second direction Y, the third side wall 112c, the second shielding wall 113b, and the fourth side wall 112d are sequentially spaced. A mounting region is provided between the third side wall 112c and the second shielding wall 113b for a part of copper bars of the power distribution unit 103. A mounting region is provided between the second shielding wall 113b and the fourth side wall 112d for the primary region 161 of the lower-layer circuit board 160. In addition, the second shielding wall 113b electrically shields, in the second direction Y, the part of copper bars of the power distribution unit 103 in the power supply apparatus 100 from the bus capacitor 163 and the power module 164 of the motor control unit 101 in the primary region 161. This helps reduce electrical interference caused when the part of copper bars of the power distribution unit 103, the bus capacitor 163 of the motor control unit 101, and the power module 164 operate, and improve electromagnetic compatibility of the power supply apparatus 100.

Refer to FIG. 9, FIG. 10, and FIG. 11. The battery connector mounting hole 111a and the second shielding wall 113b are arranged opposite to each other in the second direction Y. In this way, the battery connector 171 fastened to the battery connector mounting hole 111a can be connected to the part of copper bars of the power distribution unit 103 between the second shielding wall 113b and the third side wall 112c, so that a connection line between the battery connector 171 and a part of copper bars of the power distribution unit 103 is shortened, and a power loss is reduced.

As shown in FIG. 7 and FIG. 8, in the first direction X, a length of the secondary region 162 is less than a length of the primary region 161. In the second direction Y, the length of the secondary region 162 is less than the length of the primary region 161. In the second direction Y, sides that are of the primary region 161 and the secondary region 162 and that are away from the third side wall 112c are arranged adjacent to the fourth side wall 112d.

In this embodiment of this application, in the first direction X, the length of the secondary region 162 is denoted as L11, the length of the primary region 161 is denoted as L12, and L11<L12. As shown in FIG. 7, in the first direction X, a small length of the secondary region 162 helps the secondary region 162 be arranged below the upper-layer circuit board 150 in the third direction Z, and does not occupy much space in the power supply apparatus 100 in the first direction X. The small secondary region 162 in the first direction X provides sufficient space for mounting the plurality of magnetic components in the alternating current filter 145 between the secondary region 162 and the second side wall 112b.

As shown in FIG. 8, in the second direction Y, a length of the secondary region 162 is denoted as L13, a length of the primary region 161 is denoted as L14, and L13<L14. As shown in FIG. 9, the small secondary region 162 in the second direction Y provides sufficient mounting space for the plurality of magnetic components in the direct current filter 146, the plurality of power switching transistors 141a and the plurality of inductors 141b in the on-board charger 141, a part of the power switching transistors 142a in the direct current converter 142, a transformer 141d in the on-board charger 141, and the compressor power supply connector 173.

In this embodiment of this application, in the second direction Y, sides that are of the primary region 161 and the secondary region 162 and that face from the third side wall 112c are arranged adjacent to the fourth side wall 112d. This helps a circuit on the lower-layer circuit board 160 more quickly be transmitted to the three-phase connector mounting hole 111f close to the fourth side wall 112d, to transmit a current in the power supply apparatus 100 to the winding of the motor 300, and drive the rotor and the motor shaft of the motor 300 to rotate. This also helps a circuit on the lower-layer circuit board 160 more quickly be transmitted to the low voltage load connector mounting hole 111e close to the fourth side wall 112d, to supply power to the low voltage load. In addition, this further helps save a material of the lower-layer circuit board 160 and reduce production costs.

In an embodiment, the upper-layer circuit board 150 includes a notch 151, and the notch 151 includes an opening facing the third side wall 112c in the second direction Y and an opening facing the primary region 161 in the first direction X. As shown in FIG. 5, space between an opening side edge of the notch 151 and the third side wall 112c is used to accommodate the direct current power supply connector 172 and a part of copper bars of the power distribution unit 103.

In this embodiment of this application, the notch 151 of the upper-layer circuit board 150 provides mounting space for the direct current power supply connector 172 at the direct current power connector mounting hole 111b on the integrated groove housing 110. The notch 151 includes the opening facing the third side wall 112c in the second direction Y and the opening facing the primary region 161 in the first direction X. The third side wall 112c and the opening that is of the notch 151 and that faces the third side wall 112c in the second direction Y provide sufficient mounting space for the direct current power supply connector 172 in the second direction Y. Sufficient mounting space is provided for the direct current power supply connector 172 in the first direction X between the opening that is in the first direction X and that faces the primary region 161 and the part of copper bars of the power distribution unit 103.

In this embodiment of this application, the space between the opening side edge of the notch 151 and the third side wall 112c is used to accommodate the part of copper bars of the power distribution unit 103 and the direct current power supply connector 172. This helps mount the direct current power supply connector 172 closer to the direct current power supply connector mounting hole 111b that penetrates the third side wall 112c in the second direction Y. This also helps the part of copper bars of the power distribution unit 103 connect the direct current power supply connector 172 to the connector 171 of the battery 30 by using fewer materials, and helps the direct current power supply connector 172 more quickly transmit a high voltage current of an external power supply to the battery 30, to charge the battery 30.

In an embodiment, the motor end cover 600 and the fourth side wall 112d of the integrated groove housing 110 are arranged on a same side. As shown in FIG. 4, the reducer end cover 700 and the third side wall 112c of the integrated groove housing 110 are arranged on a same side.

In this embodiment of this application, the motor end cover 600 and the fourth side wall 112d of the integrated groove housing 110 are arranged on the same side. This helps the motor control unit 101 close to the fourth side wall 112d transmit an alternating current to the winding of the motor 300, to drive the rotor and the motor shaft of the motor 300 to rotate. In addition, this helps the low voltage filter 147 close to the fourth side wall 112d transmits a low voltage current to the low voltage load of the vehicle through a shorter path, to help reduce a power loss. The reducer end cover 700 is arranged on a same side as the third side wall 112c of the integrated groove housing 110, and the battery charge and discharge connector mounting hole 111a, the direct current power supply connector mounting hole 111b, and the power supply connector mounting hole 111c are arranged on the third side wall 112c. This helps the battery charge and discharge connector 171, the direct current power supply connector 172, and the compressor connector 173 that are close to the third side wall 112c be disposed above the reducer 200, and helps the motor control unit 101 and the low voltage filter 147 that are disposed above the motor 300 be disposed in a distributed manner. In this way, the components in the power supply apparatus 100 are arranged more regularly.

In an embodiment, the integrated groove housing 110 further includes a support column 128. As shown in FIG. 5, the support column 128 is configured to be fastened to the two bolts 131 on the cover plate 130, so that stability of the power supply apparatus 100 can be enhanced, noise radiation can be reduced, and NVH performance of the vehicle can be improved. As shown in FIG. 5, the shielding wall is connected to the support column 128, and is used to enhance structural strength of the shielding wall.

In an embodiment, the first shielding wall 113a, the fourth shielding wall 113d, and the fifth shielding wall 113e are enclosed to form a high voltage direct current common mode inductor filter region 106. Refer to FIG. 9, FIG. 10, and FIG. 11. An alternating current common mode inductor filter region 107 is formed between the third shielding wall 113c and the second side wall 112b. A 12 V power supply filter region 108 is formed between the third shielding cover 114c and the third shielding wall 113c. Electrical interference between regions is effectively reduced, electromagnetic compatibility of the power supply apparatus 100 is improved, and stable running of the power supply apparatus 100 is ensured.

In an implementation, the electrical component in the power supply apparatus 100 is directly placed into the inner cavity from a groove opening of the integrated groove housing 110, and is mounted from bottom to top of the bottom plate 120. The upper-layer circuit board 150 and the primary region 161 of the lower-layer circuit board 160 are tiled in the first direction X. The upper-layer circuit board 150 and the secondary region 162 of the lower-layer circuit board 160 are stacked in the third direction Z. In a mounting process, the circuit board does not need to be turned over, assembly is simple, and the mounting process is smooth.

In an embodiment, the upper-layer circuit board 150 and the secondary region 162 of the lower-layer circuit board 160 are stacked, and the direct current converter 142 is arranged below the upper-layer circuit board 160 by using the secondary region 162 of the lower-layer circuit board 1620 to further improve integration of the circuit board.

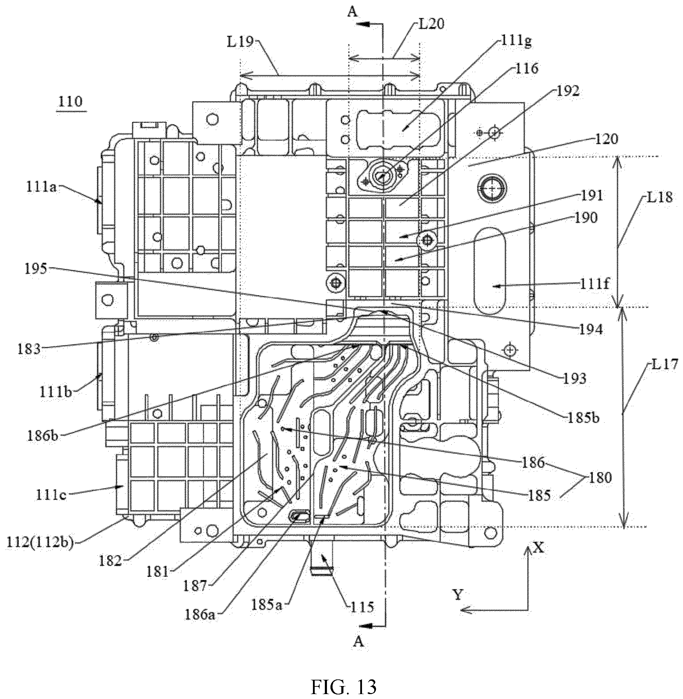

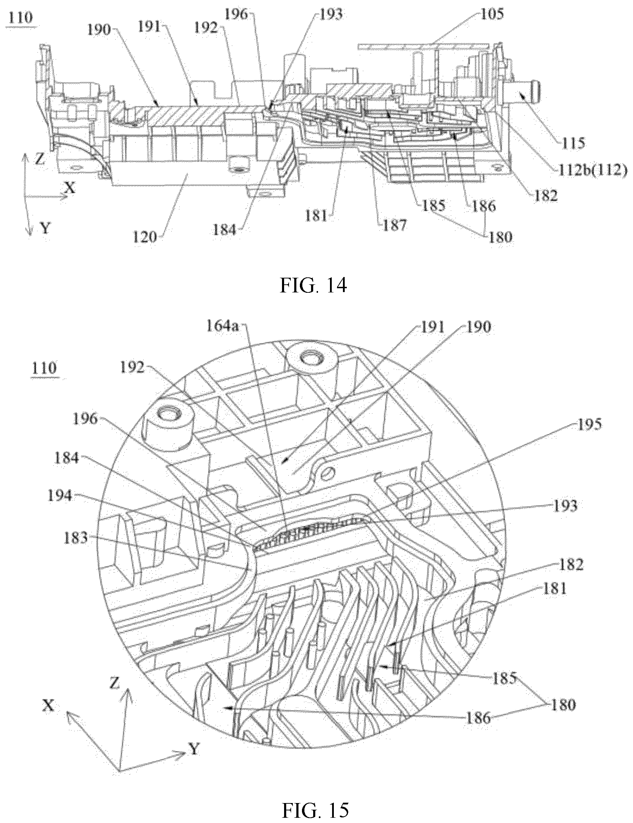

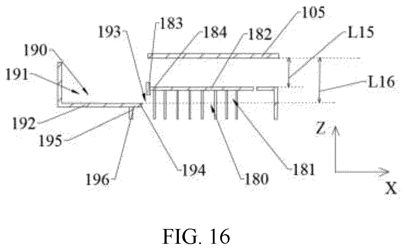

FIG. 13 is a bottom view of the integrated groove housing 110 according to an embodiment of this application. FIG. 14 is an AA cross sectional view of FIG. 13. FIG. 15 is a diagram of a partial structure of the integrated groove housing 110 according to an embodiment of this application. FIG. 16 is a diagram of structures of a first flow channel groove and a second flow channel groove according to an embodiment of this application.

As shown in FIG. 13, in an embodiment, an internal flow channel of the bottom plate 120 of the integrated groove housing 110 includes the first flow channel 181 and the second flow channel 191, and the first flow channel 181 is configured to communicate with the second flow channel 191 and the radiator 105. The first flow channel 181 and the second flow channel 191 are arranged in the first direction X. The first flow channel 181, the upper-layer circuit board 150, and the radiator 105 are sequentially stacked in the third direction Z (with reference to FIG. 5). The first flow channel 181 and the radiator 105 are configured to cool an electrical component in the on-board charger 141 carried by the upper-layer circuit board 150. The second flow channel 191 and the lower-layer circuit board 160 are stacked in the third direction Z, and the second flow channel 191 is configured to cool the power module 164 of the motor control unit 101 carried on the lower surface of the lower-layer circuit board 160.

In this embodiment of this application, the integrated groove housing 110 is configured to fasten and mount the radiator 105, the upper-layer circuit board 150, and the lower-layer circuit board 160 (as shown in FIG. 5). The radiator 105, the upper-layer circuit board 150, and the lower-layer circuit board 160 are supported by the integrated groove housing 110, so that the radiator 105, the upper-layer circuit board 150, and the lower-layer circuit board 160 are fastened to the integrated groove housing 110 with high stability. In this way overall structural strength of the power supply apparatus 100 is stronger, and an electrical connection is more stable. In an embodiment, the radiator 105 is a brazed radiator 105. When an external environment exerts external force on the power supply apparatus 100, the radiator 105, the upper-layer circuit board 150, the lower-layer circuit board 160, and the integrated groove housing 110 are not easily displaced relative to each other. This helps the power supply apparatus 100 operate in a stable state.

In this embodiment of this application, the power supply apparatus 100 generates a large amount of heat in an operating process, and heat dissipation needs to be performed on the power supply apparatus 100 to ensure that a component in the power supply apparatus 100 operates normally. As shown in FIG. 5 and FIG. 13, the bottom plate 120 includes the first flow channel 181 and the second flow channel 191. The first flow channel 181 and the second flow channel 191 are configured to the cool electrical components carried by the upper-layer circuit board 150 and the lower-layer circuit board 160 in the power supply apparatus 100. The first flow channel 181 is configured to communicate the second flow channel 191 and the radiator 105, to facilitate communication of a coolant in the power supply apparatus 100. In an embodiment, after entering the power supply apparatus 100, the coolant sequentially passes through the radiator 105, the first flow channel 181, and the second flow channel 191, to implement series circulation cooling of the coolant in the power supply apparatus 100. In an embodiment, after the coolant enters the power supply apparatus 100, a part of the coolant flows through the radiator 105 and the first flow channel 181 to the second flow channel 191, and the other part of the coolant directly flows from the first flow channel 181 to the second flow channel 191 without passing through the radiator 105. The two parts of the coolant converge in the second flow channel 191, to implement parallel circulation of the coolant in the power supply apparatus 100 for cooling.

As shown in FIG. 13, the first flow channel 181 and the second flow channel 191 are arranged in the first direction X. As shown in FIG. 5, the upper-layer circuit board 150 and the primary region 161 of the lower-layer circuit board 160 are also arranged in the first direction X, to help the first flow channel 181 and the second flow channel 191 cool the lower-layer circuit board 160 and the upper-layer circuit board 150.

In this embodiment of this application, the second flow channel 191 is configured to cool the power module 164 of the motor control unit 101 carried on the lower surface of the lower-layer circuit board 160. The second flow channel 191 and the lower-layer circuit board 160 are stacked in the third direction Z. Therefore, the second flow channel 191 covers a mounting region in which the power module 164 of the motor control unit 101 is mounted on the bottom plate 120. In this way, the second flow channel 191 cools the power module 164 of the motor control unit 101 as much as possible, thereby improving cooling efficiency.

In an embodiment, a heat dissipation structure 164a (as shown in FIG. 15) is disposed on a lower surface of the power module 164 of the motor control unit 101. The heat dissipation structure 164a is located in the second flow channel groove 190, and the heat dissipation structure 164a may be immersed in a coolant. When the coolant in the first flow channel groove 180 flows through the second flow channel groove 190, heat of the power module 164 can be taken away more quickly, thereby improving cooling efficiency of the motor control unit 101. In an embodiment, the heat dissipation structure 164a includes a plurality of heat dissipation fins distributed at intervals.

Refer to FIG. 9 and FIG. 13. The first flow channel 181 is configured to cool at least one of the transformer 141d, the plurality of inductors 141b, and the plurality of capacitors 141c in the on-board charger 141 carried on the lower surface of the upper-layer circuit board 150. The radiator 105 is configured to cool the plurality of power switching transistors 141a of the on-board charger 141 carried on the upper surface of the upper-layer circuit board 150.

In this embodiment of this application, the first flow channel 181 is located on the bottom plate 120. The transformer 141d, the plurality of inductors 141b, and the plurality of capacitors 141c in the on-board charger 141 are sequentially arranged on the lower surface of the upper-layer circuit board 150 in a second direction Y. The first flow channel 181 is configured to cool at least one of the transformer 141d, the plurality of inductors 141b, and the plurality of capacitors 141c in the on-board charger 141 carried on the lower surface of the upper-layer circuit board 150. In this way, at least one of the transformer 141d, the plurality of inductors 141b, and the plurality of capacitors 141c in the on-board charger 141 can be cooled in time when the on-board charger 141 operates. This helps reduce a temperature in the power supply apparatus 100, and ensures normal operating of the power supply apparatus 100.

In this embodiment of this application, the radiator 105 is configured to cool the plurality of power switching transistors 141a of the on-board charger 141 carried on the upper surface of the upper-layer circuit board 150. The plurality of power switching transistors 141a of the on-board charger 141 are closer to the radiator 105 than the first flow channel 181, so that the radiator 105 can cool the plurality of power switching transistors 141a of the on-board charger 141. This helps reduce the temperature in the power supply apparatus 100, and ensures normal operating of the power supply apparatus 100.

In this embodiment of this application, the first flow channel 181 and the radiator 105 are respectively configured to cool electrical components carried on the lower surface and the lower surface of the upper-layer circuit board 150. Some electrical components of the upper-layer circuit board 150 are stacked between the upper-layer circuit board 150 and the bottom plate, and some electrical components are stacked between the upper-layer circuit board 150 and the radiator 105. This not only improves cooling and heat dissipation effect of the electrical components, but also can fully use space of the upper surface and the lower surface of the upper-layer circuit board 150, so that the components are arranged more compactly, a heat dissipation and cooling region is more centralized, and heat dissipation effect is better. This improves power density and operating efficiency of the power supply apparatus 100.

In an embodiment, the lower-layer circuit board 160 includes a primary region 161 and a secondary region 162. Refer to FIG. 9 and FIG. 13. A lower surface of the primary region 161 is configured to fasten the power module 164 of the motor control unit 101, and the secondary region 162 is configured to fasten at least a part ofa part of the power switching transistors 142a of the direct current converter 142. The primary region 161 and the secondary region 162 are arranged in the first direction X. The first flow channel 181, the secondary region 162, and the upper-layer circuit board 150 are stacked in the third direction Z. The second flow channel 191 and the primary region 161 are stacked in the third direction Z.

In this embodiment of this application, the primary region 161 and the secondary region 162 are arranged in the first direction X, and the first flow channel 181 and the second flow channel 191 are arranged in the first direction X. This makes it possible for the first flow channel 181 and the second flow channel 191 to jointly cool the lower-layer circuit board 160, and helps improve cooling efficiency of the lower-layer circuit board 160. The first flow channel 181, the secondary region 162, and the upper-layer circuit board 150 are stacked in the third direction Z, so that the first flow channel 181 can not only cool the upper-layer circuit board 150, but also cool the secondary region 162 of the lower-layer circuit board 160, thereby improving efficiency of cooling the power supply apparatus 100 by the coolant. The second flow channel 191 and the primary region 161 are stacked in the third direction Z, so that the second flow channel 191 cools the primary region 161 of the lower-layer circuit board 160, to ensure normal operating of the electrical component in the lower-layer circuit board 160.

In an embodiment, the bottom plate 120 includes the first flow channel groove 180 and the second flow channel groove 190. As shown in FIG. 14 and FIG. 16, the first flow channel groove 180 is recessed in the third direction Z from a lower surface of the bottom plate 120 to the upper-layer circuit board 150, the first flow channel groove 180 is configured to form the first flow channel 181, the second flow channel groove 190 is recessed in the third direction Z from the upper surface of the bottom plate 120 and away from the lower-layer circuit board 160, and the second flow channel groove 190 is configured to form the second flow channel 191.

In this embodiment of this application, the coolant flows in the first flow channel groove 180 and the second flow channel groove 190 of the bottom plate 120, to dissipate heat in the power supply apparatus 100. As shown in FIG. 14 and FIG. 16. The first flow channel groove 180 is recessed from the lower surface of the bottom plate 120 to the upper-layer circuit board 150 in the third direction Z, to help form the first flow channel 181 on the lower surface of the bottom plate 120. In this way, arrangement of the first flow channel 181 does not affect mounting and arrangement of electrical components in the secondary region 162 of the upper-layer circuit board 150 and the lower-layer circuit board 160 in the power supply apparatus 100. The second flow channel groove 190 is recessed in the third direction Z from the upper surface of the bottom plate 120 to the direction away from the lower-layer circuit board 160. This helps form the second flow channel 191 on the upper surface of the bottom plate 120. The second flow channel 191 is formed on the upper surface of the bottom plate 120, and is closer to the lower-layer circuit board 160. This helps the second flow channel 191 cool the lower-layer circuit board 160.

In an embodiment, the first flow channel groove 180 on the lower surface of the bottom plate 120 of the integrated groove housing 110 seals the first flow channel 181 by using a friction stir welding or glue dispensing process, to implement circulation of the coolant on the lower surface of the bottom plate 120 of the power supply apparatus 100. In addition, this further helps prevent the coolant from leaking to the motor 300 and the reducer 200 of the powertrain 10, to affect normal operating of the powertrain 10. In an embodiment, a sealing plate covers a groove opening of the first flow channel groove 180, the sealing plate and the first flow channel groove 180 form the first flow channel 181 through enclosure, and the sealing plate may seal and fasten the groove opening of the first flow channel groove 180 by using glue dispensing.

As shown in FIG. 16, the power module 164 in the motor control unit 101 covers a groove opening of the second flow channel groove 190, and a heat dissipation structure 164a is disposed at the bottom of the power module 164. The heat dissipation structure 164a is accommodated in the second flow channel groove 190, and a bottom wall of the power module 164 and the second flow channel groove 190 are enclosed to form the second flow channel 191. In an embodiment, the bottom wall of the power module 164 and a bottom plate part on a periphery side of the groove opening of the second flow channel groove 190 may be sealed and fastened through welding.

As shown in FIG. 16, in the third direction Z, a spacing between a groove bottom 182 of the first flow channel groove 180 and the radiator 105 is less than a spacing between a groove bottom 192 of the second flow channel groove 190 and the radiator 105.

In this embodiment of this application, in the third direction Z, a spacing between the groove bottom 182 of the first flow channel groove 180 and the radiator 105 is denoted as L15, in the third direction Z, a spacing between the groove bottom 192 of the second flow channel groove 190 and the radiator 105 is denoted as L16, and L15<L16. As shown in FIG. 15, the first flow channel groove 180 is located on the lower surface of the bottom plate 120, L15 is small, and the coolant in the radiator 105 and the first flow channel 181 is closer to the upper-layer circuit board 150. This helps cool the upper-layer circuit board 150. The second flow channel groove 190 is located on the upper surface of the bottom plate 120, and L16 is large, to provide larger space for the second flow channel groove 190 to form the second flow channel 191. More coolants flow through the second flow channel 191, to better cool the lower-layer circuit board 160. In addition, more space is provided for mounting the electrical component of the lower-layer circuit board 160. The radiator 105, the first flow channel groove 180, and the second flow channel groove 190 in FIG. 15 are all diagrams of simplified structures.

In this embodiment of this application, the groove bottom 182 of the first flow channel groove 180 and the groove bottom 192 of the second flow channel groove 190 are staggered in the third direction Z. In comparison with a solution in which the groove bottoms are not staggered, in this solution, a length of the first flow channel groove 180 and a length of the second flow channel groove 190 in the third direction Z can be reduced, so that a length of the power supply apparatus 100 in the third direction Z can be reduced, thereby facilitating miniaturization of the power supply apparatus 100.

As shown in FIG. 13, a length of the first flow channel groove 180 in the first direction X is greater than a length of the second flow channel groove 190 in the first direction X, and a length of the first flow channel groove 180 in the second direction Y is greater than a length of the second flow channel groove 190 in the second direction Y.

In this embodiment of this application, a length of the first flow channel groove 180 in the first direction X is denoted as L17, a length of the second flow channel groove 190 in the first direction X is denoted as L18, and L17>L18. As shown in FIG. 13, L17 is large, a surface area of the first flow channel 181 adjacent to the electrical component in the upper-layer circuit board 150 is larger, and more coolants flow through the first flow channel 181 in the first flow channel groove 180. This helps improve efficiency of cooling the upper-layer circuit board 150 by the first flow channel 181. L18 is small, so that more mounting space is provided for the plurality of chips 144 of the vehicle control unit 104.

In this embodiment of this application, a length of the first flow channel groove 180 in the second direction Y is denoted as L19, a length of the second flow channel groove 190 in the second direction Y is denoted as L20, and L19>L20. As shown in FIG. 13, L19 is large. This helps the first flow channel 181 dissipate heat for more electrical components in the upper-layer circuit board 150 in the second direction Y, and improves cooling efficiency on the upper-layer circuit board 150. Because the second flow channel groove 190 is disposed on the upper surface of the bottom plate 120, L20 is small, and more mounting space is provided for a bus capacitor 163 and a power distribution unit 103 of the motor control unit 101.

In an embodiment, the groove peripheral wall 195 of the second flow channel groove 190 includes a communication hole 193, and the communication hole 193 is configured to communicate with the first flow channel groove 180. As shown in FIG. 14, FIG. 15, and FIG. 16, a part of the groove peripheral wall 194 of the second flow channel groove 190 is adjacent to a part of the groove peripheral wall 183 of the first flow channel groove 180 in the first direction X. The communication hole 193 penetrates, in the first direction X, the part of the groove peripheral wall 194 of the second flow channel groove 190 and the part of the groove peripheral wall 183 of the first flow channel groove 180 that are adjacent to each other.

In this embodiment of this application, the communication hole 193 communicates the first flow channel groove 180 with the second flow channel groove 190, so that the coolant in the first flow channel 181 can flow into the second flow channel 191 from the communication hole 193. This facilitates circulation of the coolant in the power supply apparatus 100, and helps improve a fusion degree of the power supply apparatus 100.

As shown in FIG. 16, the part of the groove peripheral wall 194 of the second flow channel groove 190 is adjacent to the part of the groove peripheral wall 183 of the first flow channel groove 180 in the first direction X, so that it is possible that the communication hole 193 is disposed on the groove peripheral wall 195 of the second flow channel groove 190, so that the second flow channel groove 190 can communicate with the first flow channel groove 180.

In this embodiment of this application, the communication hole 193 penetrates, in the first direction X, the part of the groove peripheral wall 194 of second flow channel groove 190 and the part of the groove peripheral wall 183 of the first flow channel groove 180 that are adjacent to each other. In this way, the first flow channel 181 in the first flow channel groove 180 communicate with the second flow channel 191 in the second flow channel groove 190, so that the coolant in the first flow channel 181 flows into the second flow channel 191. A flow path between the first flow channel 181 and the second flow channel 191 is shortened.

In an embodiment, the groove peripheral wall 195 of the second flow channel groove 190 includes the communication hole 193, and the communication hole 193 is configured to communicate with the first flow channel groove 180. As shown in FIG. 14, FIG. 15, and FIG. 16, a part of a groove bottom wall 196 of the second flow channel groove 190 is adjacent to a part of a groove bottom wall 184 of the first flow channel groove 180 in the third direction Z. The communication hole 193 penetrates, in the third direction Z, the part of the groove bottom wall 196 of the second flow channel groove 190 and the part of the groove bottom wall 184 of the first flow channel groove 180 that are adjacent to each other.

In this embodiment of this application, the communication hole 193 communicates the first flow channel groove 180 with the second flow channel groove 190, so that the coolant in the first flow channel 181 can flow into the second flow channel 191 from the communication hole 193. This facilitates circulation of the coolant in the power supply apparatus 100, and helps improve a fusion degree of the power supply apparatus 100.

In this embodiment of this application, the groove bottom 192 of the first flow channel groove 180 is located on the lower surface of the bottom plate 120, the groove bottom 192 of the second flow channel groove 190 is located on the upper surface of the bottom plate 120, and the part of the groove bottom wall 196 of the second flow channel groove 190 is adjacent to the part of the groove bottom wall 184 of the first flow channel groove 180 in the third direction Z. This provides space for the coolant in the first flow channel 181 in the first flow channel groove 180 to flow into the second flow channel 191 in the second flow channel groove 190.

In this embodiment of this application, the communication hole 193 penetrates, in the third direction Z, the part of the groove bottom wall 196 of the second flow channel groove 190 and the part of the groove bottom wall 184 of the first flow channel groove 180 that are adjacent to each other, so that the coolant in the first flow channel 181 can flow into the second flow channel 191 through the communication hole 193, and a flow path between the first flow channel 181 and the second flow channel 191 is shortened. This helps improve the overall fusion degree in the power supply apparatus 100.

In an embodiment, the communication hole 193 includes two parts. As shown in FIG. 14, FIG. 15, and FIG. 16, one part of the communication hole 193 penetrates, in the third direction Z, the part of the groove bottom wall 196 of the second flow channel groove 190 and the part of the groove bottom wall 184 of the first flow channel groove 180 that are adjacent to each other. The other part of the communication hole 193 penetrates, in the first direction X, the part of the groove peripheral wall 194 of second flow channel groove 190 and the part of the groove peripheral wall 183 of the first flow channel groove 180 that are adjacent to each other. In other words, the communication hole 193 enables a cooling medium to flow from the first flow channel groove 190 into the second flow channel groove 180 in the third direction Z, and also enables the cooling medium to flow from the first flow channel groove 190 into the second flow channel groove 180 in the first direction X. A speed at which the cooling medium flows from the first flow channel groove 190 into the second flow channel groove 180 is increased, and heat exchange efficiency is increased.

In an embodiment, the peripheral side wall 112 of the integrated groove housing 110 includes the liquid inlet 115, the bottom plate 120 includes the liquid outlet 116, and the groove peripheral wall 195 of the second flow channel groove 190 includes the communication hole 193. As shown in FIG. 14, the liquid inlet 115 is configured to communicate with the radiator 105 and the first flow channel groove 180, the liquid outlet 116 is configured to communicate with the second flow channel 191, and the communication hole 193 is configured to communicate with the first flow channel groove 180 and the second flow channel groove 190. The liquid outlet 116, the communication hole 193, and the liquid inlet 115 are sequentially spaced in the first direction X. The liquid outlet 116 penetrates the groove bottom 192 of the second flow channel groove 190 in the third direction Z. An opening of the liquid inlet 115 in the first direction X faces from an inner cavity of the integrated groove housing 110.

In this embodiment of this application, the liquid inlet 115 is located on the peripheral side wall 112 of the integrated groove housing 110, to facilitate arrangement of an external cooling pipe connected to the liquid inlet 115. The liquid outlet 116 is located on the bottom plate 120 of the integrated groove housing 110. This helps the heated coolant flow out of the power supply apparatus 100 in a gravity direction, and helps reduce a power loss.

In this embodiment of this application, the liquid inlet 115 is configured to communicate with the radiator 105 and the first flow channel groove 180, and the coolant in the vehicle cooling system flows into the radiator 105 and the first flow channel groove 180 from the liquid inlet 115, so that the coolant in the radiator 105 and the coolant in the first flow channel groove 180 simultaneously cool the upper-layer circuit board 150. This helps improve cooling efficiency of the power supply apparatus 100. The liquid outlet 116 is configured to communicate with the second flow channel 191, so that the coolant in the second flow channel 191 can flow out of the power supply apparatus 100 from the liquid outlet 116. The coolant from the vehicle cooling system sequentially flows through the liquid inlet 115, the first flow channel 181, the communication hole 193, the second flow channel 191, and the liquid outlet 116, or sequentially flows through the liquid inlet 115, the radiator 105, the first flow channel 181, the communication hole 193, the second flow channel 191, and the liquid outlet 116.

In this embodiment of this application, the liquid outlet 116, the communication hole 193, and the liquid inlet 115 are sequentially spaced in the first direction X, so that the first flow channel 181 and the second flow channel 191 are arranged in the first direction X, and the coolant smoothly flows through the liquid inlet 115, the communication hole 193, and the liquid outlet 116 in sequence.

In this embodiment of this application, the liquid outlet 116 penetrates the groove bottom 192 of the second flow channel groove 190 in the third direction Z, so that the external cooling pipe 116a (as shown in FIG. 3) connected to the liquid outlet 116 is disposed below the power supply apparatus 100 in the third direction Z, and the coolant flow out of the power supply apparatus 100 from the groove bottom 192 of the second flow channel groove 190 in the gravity direction, thereby reducing a power loss. The opening of the liquid inlet 115 faces away from the inner cavity of the integrated groove housing 110 in the first direction X, to facilitate connection and mounting of the external pipe connected to the liquid inlet 115.

In an embodiment, the liquid inlet 115 is located on the second side wall 112b of the integrated groove housing 110.

In an embodiment, the first flow channel groove 180 includes a separation rib 187. As shown in FIG. 13, the separation rib 187 is configured to separate the first flow channel groove 180 into two flow channel sub-grooves 185 and 186, and the two flow channel sub-grooves 185 and 186 are spaced in the second direction Y. An inlet 185a of one flow channel sub-groove 185 is configured to communicate with the liquid inlet 115 through an internal oil channel of the integrated groove housing 110, the other flow channel sub-groove 186 is configured to communicate with the outlet 105b (as shown in FIG. 6) of the radiator 105 through the internal oil channel of the integrated groove housing 110, and outlets 185b and 186b (as shown in FIG. 13) of the two flow channel sub-grooves 185 and 186 are configured to communicate with the communication hole 193 of the second flow channel groove 190.

In this embodiment of this application, the separation rib 187 is fastened to the lower surface of the bottom plate 120 and extends in the third direction Z, and the separation rib 187 separates the first flow channel groove 180 into two flow channel sub-grooves 185 and 186, so that the coolant input into the liquid inlet 115 flows through one of the flow channel sub-grooves 185 in a more centralized manner. A flowing speed of the coolant in the one flow channel sub-groove 185 is increased, so that a coolant with a low temperature is continuously input into the flow channel sub-groove 185. This helps improve cooling efficiency of the power supply apparatus 100. In addition, when the coolant input from the liquid inlet 115 is input into the radiator 105, the coolant in the radiator 105 may flow out of the power supply apparatus 100 through the another flow channel sub-groove 186.

In this embodiment of this application, the coolant from the vehicle cooling system may flow out of the power supply apparatus 100 through the liquid inlet 115, the inlet 185a of the one flow channel sub-groove 185, the one flow channel sub-groove 185, the outlet 185b of the one flow channel sub-groove 186, the communication hole 193, the second flow channel groove 190, and the liquid outlet 116 in sequence. The coolant may flow out of the power supply apparatus 100 through the liquid inlet 115, the radiator 105, the outlet 105b of the radiator 105, the other flow channel sub-groove 186, the outlet 186b of the other flow channel sub-groove 186, the communication hole 193, the second flow channel groove 190, and the liquid outlet 116 in sequence. The first flow channel groove 180 is separated into the two flow channel sub-grooves 185 and 186. When the coolant flowing in the other flow channel sub-groove 186 is a coolant whose temperature increases in the radiator 105, it can be ensured that the coolant in the flow channel sub-groove 185 is a coolant with a low temperature that is directly from the vehicle cooling system. This helps ensure cooling effect of the first flow channel groove 180 on the upper-layer circuit board 150.

As shown in FIG. 5, the inlet 105a of the radiator 105 and the outlet 105b of the radiator 105 respectively communicate with the inlet 185a (as shown in FIG. 13) of the flow channel sub-groove 185 and the inlet 186a of the another flow channel sub-groove 186 of the first flow channel groove 180 through a communication structure 129.

In an embodiment, the communication structure 129 is located inside the integrated groove housing 110, and the communication structure 129 is fastened to the bottom plate 120 and the second side wall 112b. The communication structure 129 is configured to communicate the liquid inlet 115, the inlet 105a and the outlet 105b of the radiator 105, the inlet 185a of the one flow channel sub-groove 185, and the inlet 186a of the other flow channel sub-groove 186. The communication structure 129 is sealed and fastened to the radiator 105 by using a sealing ring, to prevent the coolant from leaking, so that operating of the electrical component is not affected.

Refer to FIG. 12 and FIG. 13. The bottom plate 120 further includes a power distribution groove 121, a bus capacitor groove 122, and a three-phase connector mounting hole 111f. The power distribution groove 121 is configured to accommodate a copper bar of the power distribution unit 103, the bus capacitor groove 122 is configured to accommodate a bus capacitor 163 of the motor control unit 101, and the three-phase connector mounting hole 111f is configured to fasten a connector 177 between the motor control unit 101 and a motor winding. The three-phase connector mounting hole 111f, the second flow channel groove 190, the bus capacitor groove 122, and the power distribution groove 121 are sequentially arranged in the second direction Y.

In this embodiment of this application, the three-phase connector mounting hole 111f, the second flow channel groove 190, the bus capacitor groove 122, and the power distribution groove 121 are sequentially arranged in the second direction Y. This helps regular arrangement of electrical components on the power supply apparatus 100. A three-phase copper bar component 177, the power module 164, the bus capacitor 163, and the copper bar of the power distribution unit 103 are sequentially arranged in the second direction Y. This helps cool the power module 164 by using the coolant in the second flow channel groove 190.

In this embodiment of this application, the second flow channel groove 190 and the power distribution groove 121 are separated through the bus capacitor groove 122, to prevent a cooling medium penetrating the second flow channel groove 190 in an extreme case from affecting power transmission of the copper bar in the power distribution groove 121, and ensure cooling effect and stability of transmission power of the copper bar.

In an embodiment, the bottom plate 120 further includes the communication connector mounting hole 111g, and the communication connector mounting hole 111g is configured to fasten the connector 178 between the vehicle control unit 104 and the vehicle-mounted load. Refer to FIG. 12 and FIG. 13. The communication connector mounting hole 111g, the second flow channel groove 190, and the first flow channel groove 180 are sequentially arranged in the first direction X.

In this embodiment of this application, the communication connector mounting hole 111g is configured to fasten the connector 178 between the vehicle control unit 104 and the vehicle-mounted load. The vehicle control unit 104 is configured to transmit a communication signal of the vehicle-mounted load to the power supply apparatus 100, to control the power supply apparatus 100. The communication connector mounting hole 111g, the second flow channel groove 190, and the first flow channel groove 180 are sequentially arranged in the first direction X, to facilitate arrangement and normalization of the electrical components on the power supply apparatus 100. The liquid outlet 116 is located between the second flow channel groove 190 and the communication connector mounting hole 111g, so that when the coolant in the first flow channel groove 180 and the coolant in the second flow channel groove 190 are discharged from the external cooling pipe 116a connected to the liquid outlet 116, the external cooling pipe 116a connected to the liquid outlet 116 does not occupy too much space of the power supply apparatus 100 in the first direction X. This facilitates a compact layout of the powertrain 10, and optimizes vehicle performance.

In this embodiment of this application, the communication connector mounting hole 111g and the three-phase connector mounting hole 111f are distributed on two adjacent sides of the second flow channel groove 190, so that the cooling medium of the second flow channel groove 190 can absorb heat of the connectors 178 and 177 in the communication connector mounting hole 111g and the three-phase connector mounting hole 111f, to cool the connectors 178 and 177 in the communication connector mounting hole 111g and the three-phase connector mounting hole 111f. This helps signal transmission of the communication connector 178 in the communication connector mounting hole 111g be more stable, and helps the connector 177 in the three-phase connector mounting hole 111f transmit power more quickly, to avoid heat generation.

In an embodiment, the upper surface of the bottom plate 120 further includes a transformer groove 123, an inductor groove 124, and a direct current filter groove 125. Refer to FIG. 12 and FIG. 13. At least one of the transformer groove 123, the inductor groove 124, and the direct current filter groove 125 in the third direction Z is stacked between the first flow channel groove 180 and the upper-layer circuit board 150. The transformer groove 123, the inductor groove 124, the direct current filter groove 125, and the first flow channel groove 180 are arranged on a same side of the second flow channel groove 190 in the first direction X.

In this embodiment of this application, the transformer groove 123 and the inductor groove 124 are arranged in the second direction Y, and the transformer groove 123 and the direct current filter groove 125 are arranged in the first direction X. The transformer groove 123 is configured to accommodate the transformer 141d of the on-board charger 141, the inductor groove 124 is configured to accommodate the plurality of inductors 141b in the on-board charger 141, and the direct current filter groove 125 is configured to accommodate the magnetic component in the direct current filter 146. A layout of the transformer groove 123, the inductor groove 124, and the direct current filter groove 125 can improve structural firmness of the integrated groove housing 110. This helps improve stability of the power supply apparatus 100, and reduce electrical impact between module components.

In this embodiment of this application, at least one of the transformer groove 123, the inductor groove 124, and the direct current filter groove 125 is stacked between the first flow channel groove 180 and the upper-layer circuit board 150 in the third direction Z. This helps the coolant in the first flow channel groove 180 cool at least one of the transformer 141d of the on-board charger 141, the plurality of inductors 141b of the on-board charger 141, and the magnetic component in the direct current filter 146.

In this embodiment of this application, the transformer groove 123, the inductor groove 124, the direct current filter groove 125, and the first flow channel groove 180 are arranged on a same side of the second flow channel groove 190 in the first direction X. This helps arrange the transformer 141d of the on-board charger 141, the plurality of inductors 141b in the on-board charger 141, and the magnetic component in the direct current filter 146 on the lower surface of the upper-layer circuit board 150. This helps improve integration and fusion of the power supply apparatus 100, and further helps the first flow channel groove 180 cool the transformer 141d of the on-board charger 141 in the transformer groove 123, the plurality of inductors 141b in the on-board charger 141 in the inductor groove 124, and the magnetic component in the direct current filter 146 in the direct current filter groove 125. In this way, cooling of the power supply apparatus 100 is implemented, and stable running of the power supply apparatus 100 is ensured.

The foregoing describes in detail the all-in-one power supply apparatus, the all-in-one powertrain, and the electric vehicle that are provided in embodiments of this application. Specific examples are used in this specification to describe principles and embodiments of this application, and the foregoing embodiments are merely used to help understand the method and core ideas of this application. In addition, a person of ordinary skill in the art may make modifications to the specific embodiments and the application scope based on the idea of this application. In conclusion, the content of this specification shall not be construed as a limitation on this application.

## Claims

1. An all-in-one power supply apparatus, wherein the power supply apparatus is configured to: charge and discharge a battery, and drive a motor; and the power supply apparatus comprises an integrated groove housing, a radiator, an upper-layer circuit board, and a lower-layer circuit board;
the integrated groove housing comprises a bottom plate, the bottom plate comprises a first flow channel and a second flow channel, and the first flow channel is configured to communicate with the second flow channel and the radiator;
the first flow channel and the second flow channel are arranged in a first direction;
the first flow channel, the upper-layer circuit board, and the radiator are sequentially stacked in a third direction, and the first flow channel and the radiator are configured to cool an electrical component in an on-board charger carried on the upper-layer circuit board; and
the second flow channel and the lower-layer circuit board are stacked in the third direction, and the second flow channel is configured to cool a power module of a motor control unit carried on a lower surface of the lower-layer circuit board.

2. The power supply apparatus according to claim 1, wherein the first flow channel is configured to cool at least one of a transformer, a plurality of inductors, and a plurality of capacitors in the on-board charger carried on a lower surface of the upper-layer circuit board, and the radiator is configured to cool a plurality of power switching transistors of the on-board charger carried on an upper surface of the upper-layer circuit board.

3. The power supply apparatus according to claim 1, wherein the lower-layer circuit board comprises a primary region and a secondary region, a lower surface of the primary region is configured to fasten the power module of the motor control unit, and the secondary region is configured to fasten at least a part of power switching transistors of a direct current converter;
the primary region and the secondary region are arranged in the first direction;
the first flow channel, the secondary region, and the upper-layer circuit board are stacked in the third direction; and
the second flow channel and the primary region are stacked in the third direction.

4. The power supply apparatus according to any one of claims 1 to 3, wherein the bottom plate comprises a first flow channel groove and a second flow channel groove, the first flow channel groove is recessed in the third direction from a lower surface of the bottom plate to the upper-layer circuit board, the first flow channel groove is configured to form the first flow channel, the second flow channel groove is recessed in the third direction from an upper surface of the bottom plate and away from the lower-layer circuit board, and the second flow channel groove is configured to form the second flow channel.

5. The power supply apparatus according to claim 4, wherein in the third direction, a spacing between a groove bottom of the first flow channel groove and the radiator is less than a spacing between a groove bottom of the second flow channel groove and the radiator.

6. The power supply apparatus according to claim 4, wherein a length of the first flow channel groove in the first direction is greater than a length of the second flow channel groove in the first direction, and a length of the first flow channel groove in the second direction is greater than a length of the second flow channel groove in the second direction.

7. The power supply apparatus according to any one of claims 4 to 6, wherein a groove peripheral wall of the second flow channel groove comprises a communication hole, and the communication hole is configured to communicate with the first flow channel groove;
a part of the groove peripheral wall of the second flow channel groove is adjacent to a part of a groove peripheral wall of the first flow channel groove in the first direction; and
the communication hole penetrates, in the first direction, the part of the groove peripheral wall of the second flow channel groove and the part of the groove peripheral wall of the first flow channel groove that are adjacent to each other.

8. The power supply apparatus according to any one of claims 4 to 6, wherein a groove peripheral wall of the second flow channel groove comprises a communication hole, and the communication hole is configured to communicate with the first flow channel groove;
a part of a groove bottom wall of the second flow channel groove is adjacent to a part of a groove bottom wall of the first flow channel groove in the third direction; and
the communication hole penetrates, in the third direction, the part of the groove bottom wall of the second flow channel groove and the part of the groove bottom wall of the first flow channel groove that are adjacent to each other.

9. The power supply apparatus according to any one of claims 4 to 8, wherein a peripheral side wall of the integrated groove housing comprises a liquid inlet, the bottom plate comprises a liquid outlet, the groove peripheral wall of the second flow channel groove comprises the communication hole, the liquid inlet is configured to communicate with the radiator and the first flow channel groove, the liquid outlet is configured to communicate with the second flow channel, and the communication hole is configured to communicate with the first flow channel groove and the second flow channel groove;
the liquid outlet, the communication hole, and the liquid inlet are sequentially spaced in the first direction;
the liquid outlet penetrates the groove bottom of the second flow channel groove in the third direction; and
an opening of the liquid inlet faces away from an inner cavity of the integrated groove housing in the first direction.

10. The power supply apparatus according to claim 9, wherein the first flow channel groove comprises a separation rib, the separation rib is configured to separate the first flow channel groove into two flow channel sub-grooves, and the two flow channel sub-grooves are spaced in the second direction; and
an inlet of one of the flow channel sub-grooves is configured to communicate with the liquid inlet through an internal oil channel of the integrated groove housing, the other one of the flow channel sub-grooves is configured to communicate with an outlet of the radiator through the internal oil channel of the integrated groove housing, and outlets of the two flow channel sub-grooves are configured to communicate with the communication hole of the second flow channel groove.

11. The power supply apparatus according to any one of claims 4 to 10, wherein the bottom plate further comprises a power distribution groove, a bus capacitor groove, and a three-phase connector mounting hole, the power distribution groove is configured to accommodate a copper bar of a power distribution unit, the bus capacitor groove is configured to accommodate a bus capacitor of the motor control unit, and the three-phase connector mounting hole is configured to fasten a connector between the motor control unit and a motor winding; and
the three-phase connector mounting hole, the second flow channel groove, the bus capacitor groove, and the power distribution groove are sequentially arranged in the second direction.

12. The power supply apparatus according to any one of claims 4 to 11, wherein the bottom plate further comprises a communication connector mounting hole, and the communication connector mounting hole is configured to fasten a connector between a vehicle control unit and a vehicle-mounted load; and
the communication connector mounting hole, the second flow channel groove, and the first flow channel groove are sequentially arranged in the first direction.

13. The power supply apparatus according to any one of claims 4 to 12, wherein the upper surface of the bottom plate further comprises a transformer groove, an inductor groove, and a direct current filter groove, the transformer groove is configured to accommodate the transformer of the on-board charger, the inductor groove is configured to accommodate the plurality of inductors in the on-board charger, and the direct current filter groove is configured to accommodate a magnetic component in a direct current filter;
at least one of the transformer groove, the inductor groove, and the direct current filter groove is stacked between the first flow channel groove and the upper-layer circuit board in the third direction; and
the transformer groove, the inductor groove, the direct current filter groove, and the first flow channel groove are arranged on a same side of the second flow channel groove in the first direction.

14. An all-in-one powertrain, wherein the powertrain comprises a motor, a reducer, and the power supply apparatus according to any one of claims 1 to 13, the power supply apparatus is connected to a winding of the motor through a motor control unit to drive the motor, and a motor shaft of the motor is in transmission connection to an input shaft of the reducer.

15. An electric vehicle, wherein the electric vehicle comprises a vehicle frame, a power battery, and the powertrain according to claim 14, the vehicle frame is configured to fasten the power battery and the powertrain, and the power battery is configured to connect to the power supply apparatus.
